# EUROPEAN PATENT SPECIFICATION

(11) **EP 0 675 598 B1**
(45) Date of publication and mention of the grant of the patent: **17.09.2003**
(21) Application number: 95104742.2
(22) Date of filing: 30.03.1995
(51) Int. Cl.: H03K 17/082

(54) **Gate drive circuit device for voltage-driven semiconductor element**
Gate-Treiber-Schaltungsvorrichtung für ein spannungsgesteuertes Halbleiterelement
Dispositif d'attaque de grille pour élément semi-conducteur commandé par tension

(30) Priority: 31.03.1994 JP 6183694
(43) Date of publication of application: 04.10.1995
(60) Divisional application: 02022548.8
(73) Proprietor: FUJI ELECTRIC CO. LTD., Kawasaki 210 (JP)
(72) Inventor: Oyabe, Kazunori, Kawasaki-ku, Kawasaki 210 (JP); Fujihira, Tatsuhiko, Kawasaki-ku, Kawasaki 210 (JP); Yoshida, Kazuhiko, Kawasaki-ku, Kawasaki 210 (JP); Yano, Yukio, Kawasaki-ku, Kawasaki 210 (JP)
(74) Representative: Hoffmann, Eckart, Dipl.-Ing.

(56) References cited:
- EP-A- 0 319 047
- EP-A- 0 388 329
- EP-A- 0 523 807
- EP-A- 0 572 706
- FR-A- 2 692 415
- US-A- 4 831 280
- US-A- 4 975 599
- US-A- 4 992 683

## Description

The present invention relates to a gate drive circuit device for applying a gate drive signal to a gate of a voltage-driven semiconductor element and, more particularly, to a structure of a drive circuit device suitable for driving a voltage-driven semiconductor element connected to an inductive load.

### PRIOR ART

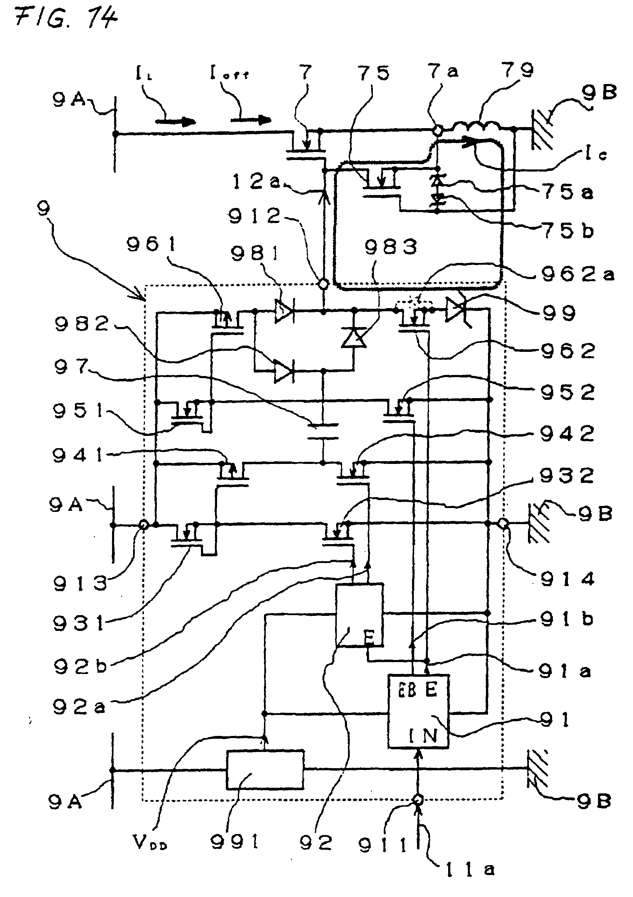

It is a long time ago that an electronic equipment using a power semiconductor element was first used as an electric apparatus for controlling an electric equipment having an inductive component such as an electromagnetic coil or an electric motor. Recently, with the semiconductor technique being developed and improved, electronic equipments have been increasingly used in this field. An example of such an electronic equipment which performs the on/off driving of an electromagnetic coil using a voltage-driven semiconductor element as a power semiconductor element is shown in Fig. 14. In other words, Fig. 14 is a circuit diagram showing the power semiconductor element and associated components in a conventional gate drive circuit device for a voltage-driven semiconductor element.

In Fig. 14, reference numeral 9 denotes a gate drive circuit device which has a power supply terminal 913 for receiving the potential of a power supply line 9A, and a reference potential terminal 914 for receiving the potential of a ground line 9B as a reference potential. Thus, the gate drive circuit device 9 receives a supply voltage V_{cc} applied from a power source (not shown) between the power supply line 9A and the ground line 9B. The gate drive circuit device 9 also has an input terminal 911 for inputting a command signal 11a, and an output terminal 912 for outputting a gate drive signal 12a corresponding to the command signal 11a, to a gate of an n-channel enhancement MOSFET (hereinafter referred to as "nEMOS") 7 which is the main voltage-driven semiconductor element. The command signal 11a is a binary signal having any one of a high level (hereinafter referred to as "H") and a low level (hereinafter referred to as "L"). The nEMOS 7 is comprised of a semiconductor element which is turned on when the gate drive signal 12a is "H" and turned off when it is "L".

The gate drive circuit device 9 includes a logic circuit section 91, an oscillator circuit section 92, an n-channel depletion MOSFET (hereinafter referred to as "nDMOS") 931, an nEMOS 932, a p-channel enhancement MOSFET (hereinafter referred to as "pEMOS") 941, an nEMOS 952, an nDMOS 951, an nEMOS 952, a pEMOS 961, an nEMOS 962, a capacitor 97, diodes 981, 982 and 983, a voltage regulation diode 99, and a constant-voltage power supply section 991. The pEMOSs 941 and 961 are connected to the power supply line 9A at their sources.

The constant-voltage power supply section 991 is a circuit device which receives a supply voltage equal to the supply voltage V_{cc} to the gate drive circuit device 9, that is the voltage between the power supply line 9A and the ground line 9B, and supplies an auxiliary supply voltage V_{DD} which is stabilized to a constant voltage value. The logic circuit section 91 is a circuit device which receives the command signal 11a, outputs a signal 91a a having the same level as that of the command signal 11a, from an enable (E) terminal thereof, and outputs a signal 91b having an inverse level of the command signal 11a, from a disenable (EB) terminal thereof. The oscillator circuit section 92 is a circuit device which receives the signal 91a, and outputs from one output terminal a signal 92a which alternates between "H" and "L" with a period shorter than the shortest duration of "H" or "L" of the command signal 11a, and from another terminal a signal 92b having the inverse level of the signal 92a,when the signal 91a is "L". The oscillator circuit section 92 does not output either of the signals 92a and 92b when the signal 91a is "H". The logic circuit section 91 and the oscillator circuit section 92 are supplied with the auxiliary supply voltage V_{DD} as a power supply therefor.

The nDMOSs 931 and 951 connected in the manner as shown in Fig. 14, as is well known, suppress currents flowing into the nDMOSs 931 and 951 to their saturation values, that is, a substantially constant current to prevent an excess current from flowing into circuit elements connected to the nDMOSs 931 and 951, when a large voltage is applied between their drain and source. The nDMOS 931 and 951 operate like a resistor element when a voltage applied between their drain and source is small.

When the command signal 11a is "L", the nEMOS 952 receives the signal 91b being "H" and is then turned on. As a result, the potential at a node between the source of the nDMOS 951 and the drain of the nEMOS 952 is lowered nearly to the potential of the ground line 9B, and the pEMOS 961 turns on. The nEMOS 962 receives the signal 91a being "L" and is turned off when the command signal 11a is "L". As a result, when the command signal 11a is "L", the voltage of the power supply line 9A is outputted from the output terminal 912 through the pEMOS 961 and the diode 981.

The nEMOS 932 is turned on by receiving the signal 92b being "H". As a result, the potential at the node between the source of the nDMOS 931 and the drain of the nEMOS 932 is lowered nearly to the potential of the ground line 9B so that the pEMOS 941 turns on. The nEMOS 942 receives the signal 92a being "L" and is turned off when the signal 92b is "H". With the above operation, when the signal 92b is H", the potential of the power supply line 9A is applied to one terminal of the capacitor 97, which is connected to the pEMOS 941, through the pEMOS 941. When the signal 92b is "L", the nEMOS 932 is turned off. As a result, the potential at the node between the source of the nDMOS 931 and the drain of the nEMOS 932 is raised nearly to the potential of the power supply line 9A, thereby turning the pEMOS 941 off. The nEMOS 942 receives the signal 92a being "H" and is then turned on when the signal 92b is "L". With the above operation when the signal 92b is "L", the potential at the terminal of the capacitor 97, which is connected to the pEMOS 941, approaches to the potential of the ground line 9B. In other words, the terminal of the capacitor 97 connected to the pEMOS 941 is alternately brought to the potential close to that of the power supply line 9A and the potential close to that of the ground line 9B in accordance with a period of the signals 92a and 92b outputted from the oscillator circuit section 92.

In addition, with the command signal 11a being "L", the pEMOS 961 is turned on as described above and the other terminal of the capacitor 97, which is connected to the diode 982, is brought to the potential close to that of the power supply line 9A. Hence, in the case where the command signal 11a is "L" and the signal 92b is "L", a voltage close to the supply voltage V_{cc} is applied across the capacitor 97 and the capacitor 97 is charged with that voltage. In the case where the command signal 11a is "L" and the signal 92b is "H", the capacitor 97 holds charges which have been charged therein, as a result of which the voltage across the capacitor 97 becomes a voltage corresponding to the amount of charges held by the capacitor 97. In this manner, charges are successively stored in the capacitor 97 as the signal 92a repeats being "H" and "L", whereby the voltage across the capacitor 97 rises up to a value close to the supply voltage V_{cc}. When the signal 92b is "H", the terminal of the capacitor 97, which is connected to the pEMOS 941, is supplied with the voltage of the power supply line 9A through the pEMOS 941 as described above, and the voltage at the terminal of the capacitor 97, which is connected to the diode 982, comes to the sum of the voltage close to the supply voltage V_{cc} and the voltage across the capacitor 97 which corresponds to the amount of charges held by the capacitor 97. The sum may be substantially twice as large as the voltage of the power supply line 9A. A voltage corresponding to the potential difference between the terminal of the capacitor 97, which is connected to the diode 982, and the ground line 98 is outputted from the output terminal 912 as a "H" value of the gate drive signal 12a during a period of the command signal 11a being "L".

The nEMOS 7 is turned on upon the gate drive signal 12a applied to its gate becoming "H". Since an electromagnetic coil 79, which is a load of the nEMOS 7, is connected between an output terminal 7a connected to the source of the nEMOS 7 and the ground line 9B, when the nEMOS 7 is on, the electromagnetic coil 79 is supplied with a voltage close to the supply voltage V_{cc} so that a current l_{L} flows through the nEMOS 7. Hence, the electromagnetic coil 79 assumes a predetermined excited state.

When the command signal 11a is changed to "H", the signal 91a a outputted from the logic circuit section 91 is changed to "H", and the signal 91b is changed to "L". Since, upon inputting the signal 91a being "H", the oscillator circuit section 92 stops outputting the signals 92a and 92b, the operation of charging the capacitor 97 is stopped. Also, upon inputting the signal 91b being "L", the nEMOS 952 is turned off. As a result, since the potential at the node between the source of the nDMOS 951 and the drain of the nEMOS 952 rises nearly up to the potential close to that of the power supply line 9A, the pEMOS 961 with its gate connected to the node is turned off. At the same time, the nEMOS 962 is turned off upon inputting the signal 91a being "H", and then the potential of the output terminal 912 approaches to the potential of the ground line 9B. As a result, for the command signal 11a changed to "H", the potential of the output terminal 912 approaches to the potential of the ground line 9B. The potential of the output terminal 912 is outputted from the output terminal 912 as an "L" value of the gate drive signal 12a during a period of the command signal 11a being "H". The nEMOS 962 must have a parasitic diode 962a connected as shown in Fig. 14 due to the manufactured structure. For this reason, in this operating state, even though a slight voltage is superimposed on the ground line 9B, a resultant current flows toward the gate of the nEMOS 7 via the parasitic diode 962a. The voltage regulation diode 99 serves to prevent this phenomenon.

The nEMOS 7 is turned off immediately after the gate drive signal 12a is switched to "L" as described above, and then starts the operation of interrupting the current l_{L} flowing through the electromagnetic coil 79. However, since the electromagnetic coil 79, which exemplifies an electric equipment having an inductive component, has an inductance L, a counter electromotive force (= -L·dl_{L}/dt) is developed by the inductance L. The counter electromotive force is developed in a direction in which a circulating current l_{c} flows in a circuit including the electromagnetic coil 79 as shown in Fig. 14. The counter electromotive force causes a voltage to be applied between the gate of the nEMOS 7 and the source which is the other main electrode thereof. A voltage-driven power semiconductor element with a source provided as an output terminal generally has the following withstand voltage value between the gate and the source or the drain as one main electrode. That is, in the general nEMOS, a withstand voltage between the gate and drain thereof has a value exceeding a withstand voltage between the drain and source thereof, which is an element withstand value. On the other hand, a withstand voltage between the gate and source is ten volts or so at a maximum, which is appreciably smaller than the withstand voltage of the power semiconductor element. Hence, for the purpose of preventing the breakdown between the gate and source due to the counter electromotive force, the voltage applied between the gate and source of the nEMOS 7 at the time of generation of the counter electromotive force is required to be suppressed to a value below its withstand voltage. For that purpose, the nEMOS 75 is provided. The voltage regulation diodes 75a and 75b bidirectionally connected between the gate and source of the nEMOS 75 are elements for prevention of the breakdown between the gate and source of the nEMOS 75.

The nEMOS 75 has its drain connected to the gate of the nEMOS 7, its source connected to the source of the nEMOS 7, and its gate connected to the ground line 98. Therefore, when the potential of the source of the nEMOS 7, that is, the potential of the output terminal 7a is made lower than that of the ground line 98 by generation of the counter electromotive force, the nEMOS 75 turns on, to thereby connect between the gate and source of the nEMOS 7. As a result, when the counter electromotive force is developed, no breakdown occurs between the gate and source of the nEMOS 7.

In the case where the nEMOS 75 is provided, a counter electromotive force, which is developed in the electromagnetic coil 79 in response to the command signal 11a switched to "H", is applied to the voltage regulation diode 99 through the ground line 9B with a polarity directed from its cathode to its anode because the nEMOS 962 is on in this state. The counter electromotive force readily exceeds a breakdown voltage which is an operating voltage of the voltage regulation diode 99. Therefore, the circulating current I_{c} due to the counter electromotive force circulates through a path which passes through the electromagnetic coil 79, the ground line 9B, the voltage regulation diode 99 and the parasitic diode 962a of the nEMOS 962 in the stated order, and returns to the electromagnetic coil 79 via the nEMOS 75.

Under the state where the circulating current I_{c} flows into that path, a voltage drop is developed between the drain and source of the nEMOS 75 by existence of an electric resistance therebetween. That voltage drop is applied between the gate and source of the nEMOS 7, whereby the nEMOS 7 becomes again conductive and in a half-on state regardless of the gate drive signal 12a being "L". As a result, a sustained current l_{off} flows into the electromagnetic coil 79 from the power supply line 9A through the nEMOS 7 in a direction in which the current l_{L} flows. In the electromagnetic coil 79, electromagnetic energy W_{L} [ = (1/2)Ll²] is stored in a period where the command signal 11a is "L". The electromagnetic energy is consumed mainly in the nEMOS 7 as an electric power which is equal to a product of the sustained current I_{off} and a voltage developed between the drain and source of the nEMOS 7 in the half-on state. Consequently, the electromagnetic coil 79 release the electromagnetic energy W_{L} to the nEMOS 7 so as to be demagnetized. Thus, the electromagnetic coil 79 assumes a non-excited state.

The above-mentioned conventional gate drive circuit device 9 is constituted on the basis of an electronic circuit generally called the charging pump and the voltage regulation diode 99 added thereto. The charging pump adapted here is to output a voltage twice as large as the supply voltage V_{cc} from the terminal of the capacitor 97 which is connected to the diode 982. The gate drive circuit device thus constituted is capable of supplying the gate drive signal 12a of a level required by the power semiconductor element which is a main semiconductor element of the voltage-driven type even though the supply voltage V_{cc} is relatively low. In addition, the gate drive circuit device has such an advantage that the gate drive circuit device having the above functions and the power semiconductor element driven by the gate drive circuit device may be formed integrally on the same semiconductor substrate to be a so-called one-chip power semiconductor element which can be readily manufactured by common semiconductor element manufacturing techniques.

There have been known a lot of cases using an IGBT and the like rather than the MOSFET for the main semiconductor element of the voltage-driven type which is driven by the gate drive circuit device.

Moreover, there have been known a lot of cases using a p-channel power semiconductor element rather than the n-channel power semiconductor element for the main semiconductor element of the voltage-driven type which is driven by the gate drive circuit device.

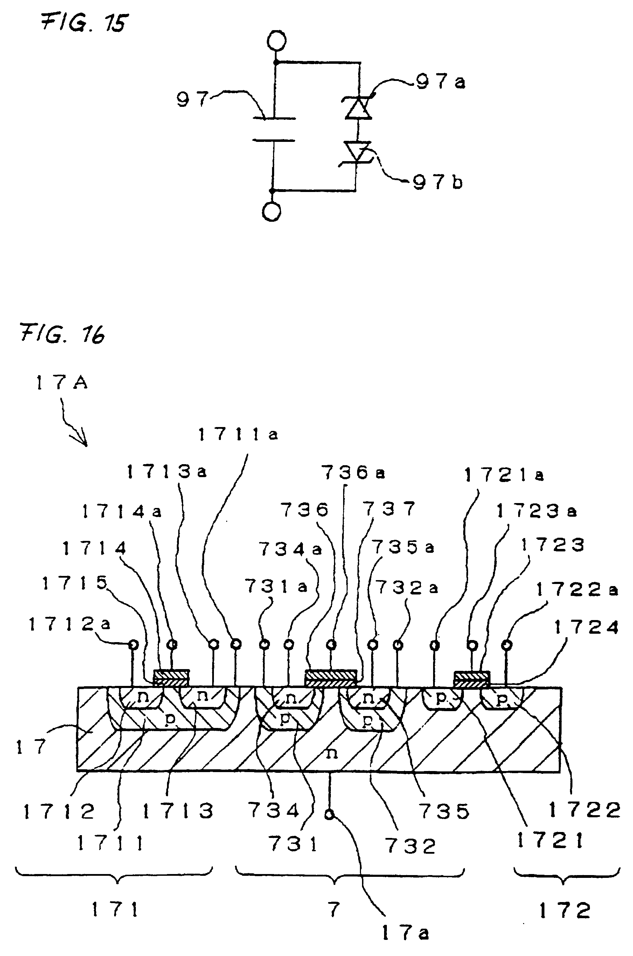

The above-mentioned conventional gate drive circuit device for the voltage-driven semiconductor element is capable of controlling an electric equipment, even though the equipment has an inductive component, by on/off-driving the voltage-driven power semiconductor element using that circuit device. However, it has been ascertained that such a conventional gate drive circuit device suffers from the following problems.
(1) In the case where a load of the power semiconductor element is an inductive electric equipment with an inductance L, sometimes the electromagnetic energy W_{L} stored in the electric equipment must be nullified at the turning off of the power semiconductor element. In such a situation, as was described in association with the conventional device, the electromagnetic energy is generally absorbed by a section of the power semiconductor element. In this case, a time required for nullifying the electromagnetic energy W_{L} stored in the electric equipment is satisfactorily shortened with an increase in the amount of energy which can be absorbed by the power semiconductor element per unit time. The electromagnetic energy absorbed by the power semiconductor element per unit time relates to a product of a drain-source voltage of the power semiconductor element and the current I_{off} flowing from its drain to its source at that time, and the absorption of the energy W_{L} in the prior art is performed by the power semiconductor element in the half-on state. The drain-source voltage of the power semiconductor element in the half-on state is several tens to 50 percent of the withstand voltage of the power semiconductor element, which is remarkably lower than its withstand voltage. Hence, the energy absorption capability of the power semiconductor element is not sufficiently utilized. Consequently, a long time is required for absorbing the electromagnetic energy W_{L} stored in the inductive electric equipment by the power semiconductor element at the turning off of the power semiconductor element. This has been limiting the high-speed operation of the electric equipment.
(2) In forming the gate drive circuit device 9 integrally with the semiconductor substrate, an insulating film formed on the semiconductor substrate by the general technique for manufacturing semiconductor elements is utilized as a dielectric for the capacitor 97. The withstand voltage of the insulating film of this type is as low as several ten volts at a maximum. Therefore, the capacitor 97 in this case, as shown in Fig. 15, is generally used to be connected in parallel with voltage regulation diodes 97a and 97b connected bidirectionally. Since a voltage close to the supply voltage V_{cc} is applied across the capacitor 97 as described above, when the supply voltage V_{cc} is varied to a higher value, a voltage exceeding the breakdown voltage of the voltage regulation diodes 97a and 97b is applied across the capacitor 97. In this case, a large reverse current flows into the voltage regulation diodes 97a and 97b in a path formed by the diode 982, the voltage regulation diodes 97a, 97b, the nEMOS 942 and the ground line 9B in the stated order, in accordance with the well-known operation of the voltage regulation diodes. That current is entirely useless for the gate drive circuit device 9. In particular, in a device used under a high supply voltage, or a device used under a wide range of supply voltages such as automobile electrical equipment, that useless current causes an increase in current consumption in the gate drive circuit device 9.

### SUMMARY OF THE INVENTION

The present invention has been made in view of the problems with the above-mentioned prior art, and a first object of the invention is to provide a gate drive circuit device for a voltage-driven semiconductor element which is capable of reducing a time required for absorbing an electromagnetic energy W_{L} stored in an inductive electric equipment in a section of the power semiconductor element. A second object of the invention is to provide a gate drive circuit device for a voltage-driven semiconductor element which is capable of suppressing an increase of a current consumption at a high supply voltage.

These objects are achieved with gate drive circuit device as claimed wherein specific embodiments of the invention are subject-matter of the dependent claims.

### OPERATION

With a gate drive circuit device according to claim 1 the following effect can be obtained.

As was described above, in the case where the load connected to the main semiconductor element has an inductance L, a high counter electromotive force is developed from the load when the command signal is switched from the on-command to the off-command. In response to a current flowing through nEMOS 75 the gate potential of the power semiconductor element is lowered below the reference potential. With the lowered gate potential the power semiconductor element is turned half-on. It is obvious that, with the lowered potential of the gate of the power semiconductor element, currents flow through nEMOS 75 from not only the point of the reference potential but also the power supply. Thus, currents must be prevented from flowing both from the power supply side and the reference potential side. Since the power supply side switching means is disposed between the power supply side end of the gate drive signal generator and the power supply, turning the power supply side switching means off is able to securely prevent the current from flowing from the power supply. The reference potential side switching means being disposed between the reference potential side end of the gate drive signal generator and the reference potential, its turning off is able to secure the current being prevented from flowing from the point of the reference potential.

In this manner, the voltage due to the counter electromotive force is not applied to the gate drive signal generator but to the power semiconductor element and the voltage stabilizing means by turning both the power supply side switching means and the reference potential side switching means off. For this, the operating voltage of the voltage stabilizing means being set to a value slightly lower than the withstand voltage of the power semiconductor element, the electromagnetic energy W_{L} stored in the load at the time of the on-operation of the load is absorbed mainly by the voltage stabilizing means or power semiconductor element, and the power semiconductor element does not suffer from a breakdown due to the counter electromotive force. Moreover, to set the operating voltage of the voltage stabilizing means to the value slightly lower than the withstand voltage of the power semiconductor element enables the voltage stabilizing means and the power semiconductor element to absorb an increased amount of energy per unit time in comparison with the prior art.

With the operation just described, the counter electromotive force generated at the load at the turning off of the power semiconductor element is applied to the turned off power supply side switching means and/or reference potential side switching means. At this time, with the composition of the voltage-driven semiconductor elements constituting the power supply side switching means and/or reference potential side switching means, according to claim 2, those semiconductor elements can perform desired operation without any difficulty even under the condition where a voltage due to a counter electromotive force is applied. Hence, the gate drive circuit device can be entirely constituted with electronic circuit parts for which the power supply side switching means and/or reference potential side switching means are composed without providing switching means having contacts.

The operation of the structure according to claim 3 will be described.

In obtaining the operation of the composition according to claim 2, a description will be given first of a case where the main n-type voltage-driven semiconductor element and the voltage-driven semiconductor element forming the reference potential switching means are formed on the same semiconductor substrate. Fig. 16 is a longitudinal cross sectional view schematically showing a one-chip power semiconductor element in which the main n-type voltage-driven semiconductor element, the voltage-driven semiconductor element forming the reference potential side switching means, and the voltage-driven semiconductor element forming the power supply side switching means are formed integrally on the same semiconductor substrate. In Fig. 16, reference numeral 17A denotes a one-chip power semiconductor element where an n-type EMOS 171 and a pEMOS 172 are formed integrally on a n-type semiconductor substrate 17 on which an nEMOS 7 constituting a main n-type voltage-driven semiconductor element is formed by the common semiconductor manufacturing technique.

The nEMOS 7 is formed as a vertical nEMOS on the semiconductor substrate 17 constituting its drain. The nEMOS 7 includes p-type wells 731 and 732, n-type regions 734 and 735 constituting sources of the nEMOS 7, an aluminum film 736 constituting a gate electrode film, and a oxide film 737 constituting a gate insulating film. A drain terminal 17a is extended from the semiconductor substrate 17, back gate terminals 731a and 732a are extended from the p-type wells 731 and 732, source terminals 734a and 735a are extended from the n-type regions 734 and 735, and a gate terminal 736a is extended from the film 736.

The nEMOS 171 is a voltage-driven semiconductor element as the reference potential side switching means and is formed on the semiconductor substrate 17 as a horizontal nEMOS. The nEMOS 171 includes a p-type well 1711, an n-type region 1712 forming its drain, an n-type region 1713 forming its source, an aluminum film 1714 forming a gate electrode film, and an oxide film 1715 forming a gate insulating film. A back gate terminal 1711a is extended from the p-type well 1711, a drain terminal 1712a is extended from the n-type region 1712, a source terminal 1713a is extended from the n-type region 1713, and a gate terminal 1714a is extended from the film 1714.

The pEMOS 172 is a voltage-driven semiconductor as the power supply side switching means and formed on the semiconductor substrate 17 as a horizontal pEMOS. The pEMOS 172 includes a p-type region 1721 forming its source, a p-type region 1722 forming its drain, an aluminum film 1723 forming a gate electrode film, and an oxide film 1724 forming a gate insulating film. A source terminal 1721a is extended from the p-type region 1721, a drain terminal 1722a is extended from the p-type region 1722, and a gate terminal 1723a is extended from the film 1723.

In the one-chip power semiconductor element 17A thus constituted, the back gate terminal 1711a of the nEMOS 171 must be connected to the ground line 9B which is the lowest potential level within the semiconductor substrate 17. When the potential of that gate becomes lower than that of the ground line 9B by switching the nEMOS 7 from the on-operation to the off-operation, the potential of the n-type region 1712, which forms the drain of the nEMOS 171 connected to the gate side thereof, is lowered below the potential of the ground line 9B. Hence, in this situation, the potential of the n-type region 1712 is lowered below the potential of the p-type well 1711. As a result, a p-n junction between the p-type well 1711 and the n-type region 1712 is forward-biased, and a current flows in a path formed by the ground line 98, the p-type well 1711, the n-type region 1712 (which is the drain of the nEMOS 171), and the gate of the nEMOS 7 in the stated order. In other words, the nEMOS 171 is not able to serve as the reference potential side switching means.

On the contrary, according to claim 3 the voltage-driven semiconductor element forming the reference potential side switching means is made to be constituted with a channel of a conductivity type different from that of the channel of the main voltage-driven semiconductor element, and the back gate of the voltage-driven semiconductor element is connected to a portion with a potential higher than that of a main electrode thereof connected to the gate drive signal generator side. With this composition, in the case where the main semiconductor element is the nEMOS 7, the voltage-driven semiconductor element forming the reference potential side switching means is of the p-type. For example, a pEMOS is used therefor. In the case of using the pEMOS corresponding to the nEMOS 7, the back gate of that pEMOS is connected, on the basis of this embodiment, for example, to a point of the highest potential level of the semiconductor substrate on which the nEMOS 7 and the pEMOS are integrally formed. Hence, even though the gate of the nEMOS 7 is lower than the potential of the ground line 9B, there is no formation of a current path due to a forward-biased p-n junction. As a result, the voltage-driven semiconductor element serving as the reference potential side switching means can be formed integrally with the semiconductor substrate on which the main voltage-driven semiconductor element is formed.

The operation of the structure according to claim 4 will be described.

An example where a voltage-driven semiconductor element of the reference potential side switching means is a pEMOS will be described. Generally, in order to turn the pEMOS on or to hold the pEMOS on, the potential of its gate must be lower than that of its source. In the pEMOS of the present invention, from the necessary factor of the invention, when the pEMOS is on, the potential of its source electrode as the other main electrode is equal to the reference potential which is the potential of the drain electrode as one main electrode. Hence, by maintaining the gate potential of the pEMOS at a value lower than that of the reference potential, the pEMOS can be held in a sufficiently stable on-state.

The operation of the structure according to claim 5 will be described.

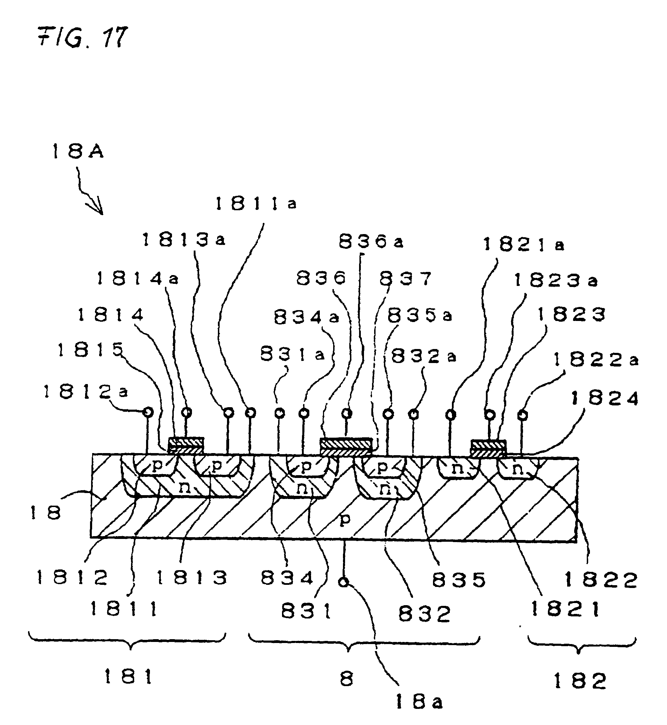

In obtaining the effect of the operation of the composition according to claim 2, a case where the main voltage-driven semiconductor element and the voltage-driven semiconductor element forming the power supply side switching means are both p-type and formed on the same semiconductor substrate will be described. Fig. 17 is a longitudinal cross sectional view schematically showing a one-chip power semiconductor element where a p-type main voltage-driven semiconductor element, a voltage-driven semiconductor element serving as the power supply switching means, and a voltage-driven semiconductor element serving as the ground potential side switching means are integrally formed on the same semiconductor substrate. In Fig. 17, reference numeral 18A denotes a one-chip power semiconductor element in which a pEMOS 181 and an nEMOS 182 are formed integrally with a p-type semiconductor substrate 18 in which a pEMOS 8 forming a main p-type voltage-driven semiconductor element is formed, by the common semiconductor manufacturing technique.

The pEMOS 8 is formed as a vertical pEMOS on the semiconductor substrate 18 being its source, and includes n-type wells 831, 832, p-type regions 834 and 835 both forming drains, an aluminum film 836 forming a gate electrode film, and an oxide film 837 forming a gate insulating film. A source terminal 18a is extended from the semiconductor substrate 18, back gate terminals 831a and 832a are extended from the p-type wells 831 and 832, drain terminals 834a and 835a are extended from the p-type regions 834 and 835, and a gate terminal 836a is extended from the film 836.

The pEMOS 181 is a voltage-driven semiconductor element serving as a power supply side switching means, and is formed on the semiconductor substrate 18 as a horizontal pEMOS. The pEMOS 181 includes an n-type well 1811, a p-type region 1812 forming a source, a p-type region 1813 forming a drain, an aluminum film 1814 forming a gate electrode film, and an oxide film 1815 forming a gate insulating film. A back gate terminal 1811a is extended from the n-type well 1811, a source terminal 1812a is extended from the p-type region 1812, a drain terminal 1813a is extended from the p-type region 1813, and a gate terminal 1814a is extended from the film 1814.

The nEMOS 182 is a voltage-driven semiconductor element serving as the reference potential side switching means, and is formed on the semiconductor substrate 18 as a horizontal nEMOS. The nEMOS 182 includes an n-type region 1821 forming a drain, an n-type region 1822 forming a source, an aluminum film 1823 forming a gate electrode film, and an oxide film 1824 forming a gate insulating film. A drain terminal 1821a is extended from the n-type region 1821, a source terminal 1822a is extended from the n-type region 1822, and a gate terminal 1823a is extended from the film 1823.

An example in which the pEMOS 8 is used as a power semiconductor element is basically the same of the example described with respect to the prior art using the nEMOS 7 as the power semiconductor element, except that the electromagnetic coil 79 forming a load is connected between the source of the pEMOS 8 and the power supply line 9A. Also, a pEMOS is connected between the source and gate of the pEMOS 8. The connected pEMOS corresponds to the nEMOS 75 for the power semiconductor element nEMOS 7. The gate of the pEMOS is connected to the power supply line 9A. In using the pEMOS 8 as the power semiconductor element, the pEMOS 8 switched from the on-operation to the off-operation raises its source potential higher than the potential of the power supply line 9A by the counter electromotive force generated from the electromagnetic coil 79. As a result, the potential of the gate of the pEMOS 8 is also raised higher than that of the power supply line 9A because of the existence of the pEMOS.

In the one-chip power semiconductor element 18A thus constituted, the terminal 1811a must be connected to the power supply line 9A. The potential of the gate of the pEMOS 8 raised higher than that of the power supply line 9A also raises the potential of the p-type region 1813, which forms the drain of the pEMOS 181 and is connected to the gate side of the pEMOS 8, higher than the potential of the power supply line 9A. Therefore, in this case, the potential of the p-type region 1813 is raised higher than that of the n-type well 1811. As a result, the p-type region 1813 and the n-type well 1811 are forward-biased, and a current flows in a path constituted by the power supply line 9A, the p-type region 1813 (drain of the pEMOS 181), the n-type well 1811, and the gate of the pEMOS 8 in the stated order. In other words, the pEMOS 181 is not able to serve as the power supply side switching means.

On the contrary, according to the present invention as claimed in claim 5, the voltage-driven semiconductor element forming the power supply side switching means is composed of a voltage-driven semiconductor element having a channel of a conductivity type different from that of a channel of the main voltage-driven semiconductor element and a back gate being connected to a point having a potential lower than that of its main electrode connected to the gate drive signal generator side. With this structure, for the main semiconductor element pEMOS 8, an nEMOS, for example, is used as the voltage-driven semiconductor element forming the power supply side switching means. In this case of using the nEMOS in contrast to the pEMOS, the back gate of the nEMOS is to be connected to a point of the lowest potential of, for example, the semiconductor substrate on which the pEMOS 8 and the nEMOS are integrally formed. Therefore, even though the potential of the gate of the pEMOS 8 rises higher than that of the power supply line 9A, no current path due to a forward-biased p-n junction is formed in the nEMOS. Hence, the voltage-driven semiconductor element serving as the power supply side switching element can be integrated on the semiconductor substrate on which the main voltage-driven semiconductor element is formed.

The operation of the structure according to claim 6 will be described.

An example in which the voltage-driven semiconductor element of the power supply side switching means is an nEMOS will be described. In general, in order to turn the nEMOS on or to hold the on-state, the potential of its gate must be higher than that of its source. In the nEMOS of the present invention, from the essential factors of the invention, the potential of the source forming the other main electrode of the on-state nEMOS becomes equal to the potential of the power supply, which is the potential of the drain forming one main electrode thereof. Therefore, by maintaining the gate potential of the nEMOS at a value higher than that of the power supply, the nEMOS can be held in a sufficiently stable on-state.

With composition according to claims 7 and 8, applied to the gate of the voltage-driven semiconductor element of the auxiliary reference voltage circuit device is a voltage due to a built-in potential of the voltage regulation diode when the power voltage is equal to or under a breakdown voltage of the voltage regulation diode, and voltage equal to the difference between the supply voltage and the breakdown voltage of the voltage regulation diode when the supply voltage exceeds the sum of the voltage due to the built-in potential and the breakdown voltage of the voltage regulation diode. Accordingly, the voltage-driven semiconductor element of the auxiliary reference voltage circuit device is adapted to output an auxiliary reference voltage having a substantially constant difference from the supply voltage, which is the same as the breakdown voltage of the voltage regulation diode. Since the gate drive signal generator is supplied with its power from between the supply voltage and this auxiliary reference voltage, even though the supply voltage varies, a voltage supplied to the gate drive signal generator is regulated to be equal to or under the breakdown voltage of the voltage regulation diode.

As a result, a circuit element of the drive signal generator to which the supply voltage is applied, for example, a capacitor for the charging pump, can be supplied with a voltage restrained to the same level as the breakdown voltage of the voltage regulation diode at the highest.

With the structure according to claim 11 a voltage outputted from the constant-voltage circuit device is reduced by a voltage generated by the negative voltage generating circuit device. Therefore, a voltage generated from the constant-voltage circuit device under the supply voltage equal to or lower than the breakdown voltage of the voltage regulation diode has a value to which the voltage due to the built-in potential of the voltage regulation diode is reduced by a voltage generated by the negative voltage generating circuit device. Also, the supply voltage at which a gate voltage, a differential voltage between the supply voltage and the breakdown voltage of the voltage regulation diode, starts to be generated is a value to which the sum of the voltage due to the built-in potential and the breakdown voltage of the voltage regulation diode is reduced by a voltage generated by the negative voltage generating circuit device.

As a result, a range of the supply voltage, in which the difference between the supply voltage and the auxiliary reference voltage generated by the auxiliary reference voltage circuit device is substantially constant as being equal to the breakdown voltage of the voltage regulation diode, can be expanded toward the lower voltage range by an amount of voltage generated by the negative voltage generating circuit device.

Hereinafter, a description will be given in more detail of the embodiments of the present invention with reference to the accompanying drawings wherein like reference signs designate like parts.

### BRIEF DESCRIPTION OF THE DRAWINGS

- Fig. 1: is a block diagram of one embodiment of a gate drive circuit device according to the present invention showing its circuit with a power semiconductor element and associated components.
- Fig, 2: is a circuit diagram illustrating the gate drive circuit device shown in Fig. 1.
- Fig. 3: is a block diagram of another embodiment of a gate drive circuit device according to the present invention, in which its circuit is shown with a power semiconductor element and associated components which are different from those in Fig. 1.
- Fig. 4: is a block diagram of still another embodiment of a gate drive circuit device according to the present invention in which its circuit is shown with a power semiconductor element and associated components.
- Fig. 5: is a circuit diagram of still another embodiment of a gate drive circuit device according to the present invention, in which a power semiconductor element is shown with associated components.
- Fig. 6: is a circuit diagram showing the auxiliary gate drive signal generating circuit shown in Fig. 5.
- Fig. 7: is a circuit diagram of still another embodiment of a gate drive circuit device according to the present invention, in which a power semiconductor element is shown with associated components.
- Fig. 8: is a circuit diagram of still another embodiment of a gate drive circuit device according to the present invention, in which a power semiconductor element is shown with associated components.
- Fig. 9: is a circuit diagram of stili another embodiment of a gate drive circuit device according to the present invention, in which a power semiconductor element is shown with associated components.
- Fig. 10: is a circuit diagram showing the auxiliary reference voltage circuit device shown in Fig. 9.
- Fig. 11: is a graph showing a dependency of a gate voltage and auxiliary reference voltage on a supply voltage.
- Fig. 12: is a circuit diagram showing an auxiliary reference voltage circuit device applied to still another embodiment of a gate drive circuit device according to the present invention.
- Fig. 13: is a graph showing a dependency of a gate voltage and auxiliary reference voltage on a supply voltage.
- Fig. 14: is a circuit diagram showing a power semiconductor element and associated components in a conventional gate drive circuit device for a voltage-driven semiconductor element.
- Fig. 15: is a circuit diagram showing a capacitor used in a charging pump.
- Fig. 16: is a longitudinal cross sectional view schematically showing a one-chip power semi-conductor element in which a main n-type voltage-driven semiconductor element, a voltage-driven semiconductor element forming a reference potential side switching means, and a voltage-driven semiconductor element forming a power supply side switching means are formed integrally on the same semiconductor substrate.
- Fig. 17: is a longitudinal cross sectional view schematically showing a one-chip power semi-conductor element where a p-type main voltage-driven semiconductor element, a voltage-driven semiconductor element serving as the power supply switching means, and a voltage-driven semiconductor element serving as the ground potential side switching means are integrally formed on the same semiconductor substrate.

### Embodiment 1:

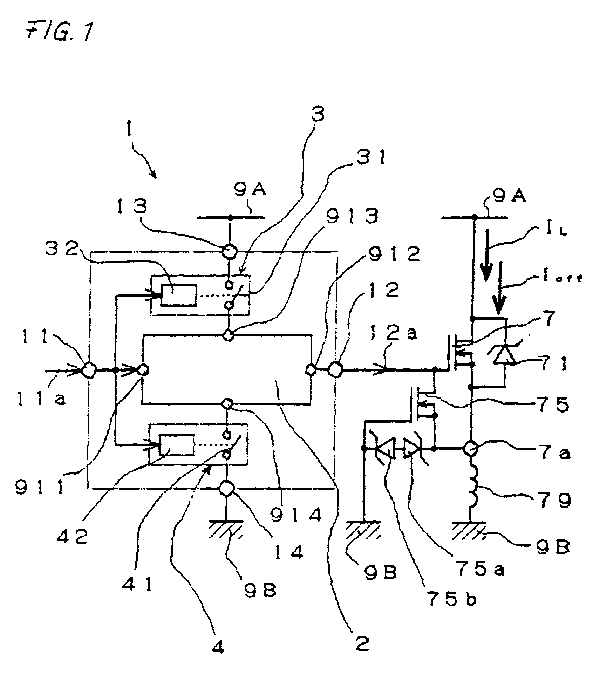

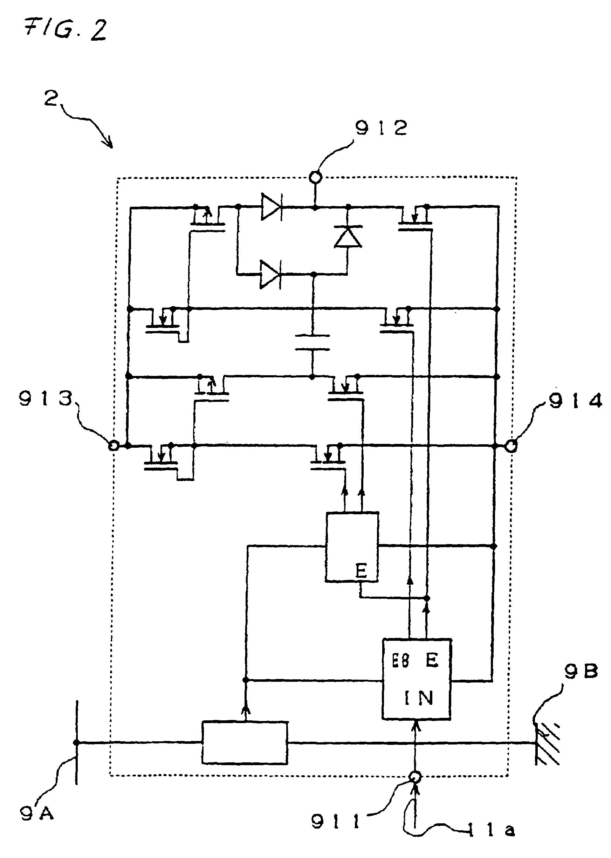

Fig. 1 is a block diagram of one embodiment of a gate drive circuit device for a voltage-driven semiconductor element corresponding to the present invention showing its circuit with a power semiconductor element and associated ones. Fig. 2 is a circuit diagram of the gate drive signal generator shown in Fig. 1. In Figs. 1 and 2, the same elements as those of the conventional gate drive circuit device for the voltage-driven semiconductor element are designated with the same reference numerals, and their description will be omitted. In Fig. 2, with respect to the reference numerals shown in Fig. 14, only the representative ones are indicated.

In Figs. 1 and 2, reference numeral 1 denotes a gate drive circuit device for a voltage-driven semiconductor element, for which a circuit composed with the voltage regulation diode 99 removed from the conventional gate drive circuit device 9 shown in Fig. 14 is used as a gate drive signal generator 2 and a power supply side switching means 3 and a reference potential side switching means 4 are added thereto. The power supply side switching means 3 includes a switching device 31 for switching an electric circuit and an operating section 32 for allowing the switching device 31 to perform the switching operation. The switching device 31 is connected between a power supply terminal 13 of the gate drive circuit device 1 and a power supply terminal 913 of the gate drive signal generator 2. The operating section 32 receives a command signal 11a and closes the switching device 31 when the command signal 11a is an on-command, while it opens the switching device 31 when it is an off-command.

The reference potential side switching means 4 includes a switching device 41 for switching the electric circuit and an operating section 42 for allowing the switching device 41 to perform the switching operation. The switching device 41 is connected between a reference potential terminal 14 of the gate drive circuit device 1 and a reference potential terminal 914 of the gate drive signal generator 2. The operating section 42 receives the command signal 11a, and closes the switching device 41 when the command signal 11a is the on-command, but opens the switching device 41 when it is the off-command.

An nEMOS 7, whose gate is connected to an output terminal 912 of the gate drive signal generator 2 through an output terminal 12 of the gate drive circuit device 1 for the gate drive signal 12a, is connected in parallel with a voltage regulation diode 71 as a voltage stabilizing means between the drain and source thereof, as shown in Fig. 1. The voltage regulation diode 71 has a breakdown voltage, which is an operating voltage thereof, set to a value slightly lower than the withstand voltage of the nEMOS 7. Reference numeral 11 denotes an input terminal of the gate drive circuit device 1 to which the command signal 11a is inputted.

In the embodiment thus constituted as shown in Figs. 1 and 2, by turning the nEMOS 7 off with the gate drive signal 12a switched from "H" to "L", the electromagnetic coil 79 generates a counter electromotive force. This is completely identical with the case of the conventional gate drive circuit device 9.

In the gate drive circuit device 1 in accordance with the present invention, simultaneously with the nEMOS 7 being turned off by inputting the command signal 11a which is the off-command, the switching device 31 and the switching device 41 are opened. Therefore, the voltage due to the counter electromotive force is applied only to a parallel circuit consisting of the nEMOS 7 and the voltage regulation diode 71. When the counter electromotive force is applied to that parallel circuit, the voltage regulation diode 71, whose breakdown voltage is set to the above-mentioned value, operates in its breakdown region with the counter electromotive force exceeding that breakdown voltage. As a result, a current l_{off} due to release of an electromotive energy W_{L} (which has been stored while the nEMOS 7 was on) stored in the electromagnetic coil 79 flows into the voltage regulation diode 71. In other words, most of the electromagnetic energy W_{L} is absorbed with the voltage regulation diode 71. The degree of the electromagnetic energy W_{L} absorption with the voltage regulation diode 71 is remarkably increased in comparison with a case where the electromagnetic energy is absorbed with the nEMOS 7 in a half-on state as in the conventional gate drive circuit device 9, because the breakdown voltage of the voltage regulation diode 71 is set to a value slightly lower than the withstand voltage of the nEMOS 7. As a result, a time required for absorbing the electromagnetic energy W_{L} with the voltage stabilizing means can be reduced.

### Embodiment 2:

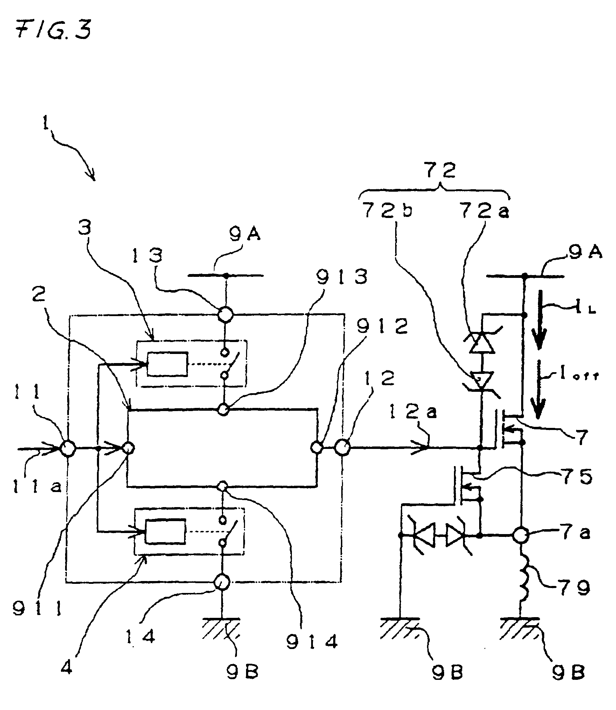

Fig. 3 is a block diagram of another embodiment of a gate drive circuit device for a voltage-driven semiconductor element corresponding to the present invention, in which its circuit is shown with a power semiconductor element and associated components which are different from those in Fig. 1. In Fig. 3, the same elements as those shown in Figs. 1 and 2 and those in Fig. 14 are designated with the same reference numerals, and their description will be omitted. In Fig. 3, with respect to the reference numerals shown in Figs. 1, 2 and 14, only the representative ones are indicated.

In Fig. 3, the nEMOS 7 to be driven by the gate drive circuit device 1 is connected to a voltage regulation diode device 72 forming the voltage stabilizing means between a drain and gate thereof. The voltage regulation diode device 72 is constituted with voltage regulation diodes 72a and 72b connected in series to each other bidirectionally. The voltage regulation diode 72a has a breakdown voltage as its operating voltage which is set to a value slightly lower than the withstand voltage of the nEMOS 7, so that the voltage regulation diode 72a operates in the breakdown region when a voltage is applied between the drain and source of the nEMOS 7. The voltage regulation diode 72b is adapted to block a current which is to flow from the gate of the nEMOS 7 toward the power supply line 9A.

With the above structure of the embodiment shown in Fig. 3, with the gate drive signal 12a switched from "H" to "L", a counter electromotive force is generated from the electromagnetic coil 79 by turning the nEMOS 7 off. This is completely identical with the cases of the gate drive circuit device 1 of the embodiment 1 and the conventional drive circuit device 9.

In the embodiment 2, by inputting of the command signal 11a as the off-command, a voltage due to the above counter electromotive force is applied only to the nEMOS 7 connected with the voltage regulation diode device 72. When the voltage due to the counter electromotive force is applied to the nEMOS 7, the voltage regulation diode 72a, whose breakdown voltage is set to the above value, operates in the breakdown region with the applied voltage exceeding a value corresponding to that breakdown voltage. As a result, the nEMOS 7 comes in an on-state with its drain-source voltage slightly lower than its withstand voltage, whereby most of the current l_{off} at the release of the electromagnetic energy flows in the nEMOS 7. In other words, most of he electromagnetic energy W_{L} is absorbed with the nEMOS 7. The degree of the electromagnetic energy W_{L} absorption with the NEMOS 7 is remarkably increased in comparison with a case where it is absorbed with the NEMOS 7 in the half-on state as in the conventional gate drive circuit device 9. Therefore, a time can be reduced for absorbing the electromagnetic energy W_{L} with the voltage stabilizing means. The embodiment 2 has an advantage that the current capacity of the voltage regulation diode 72a can be reduced in comparison with the voltage regulation diode 71 in the embodiment 1.

### Embodiment 3:

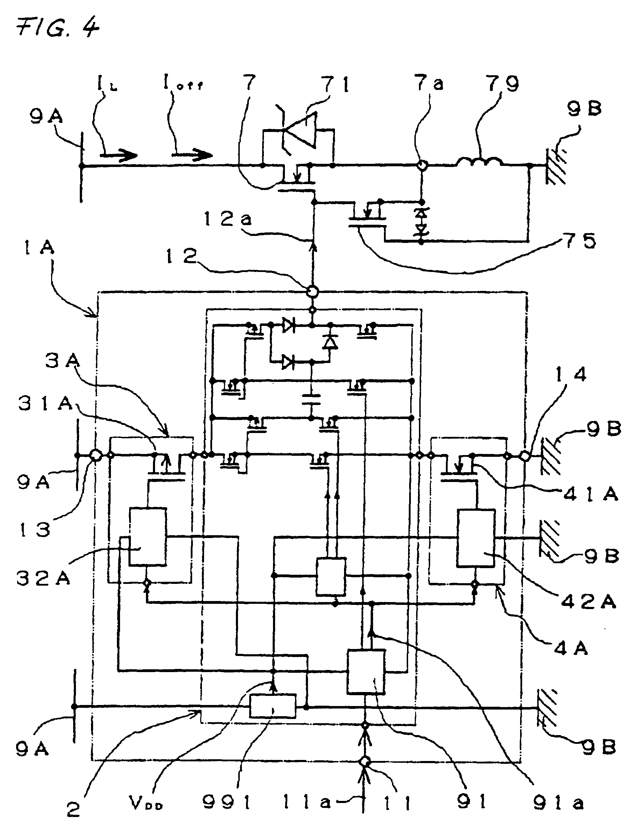

Fig. 4 is a block diagram of still another embodiment of a gate drive circuit device for a voltage-driven semiconductor element corresponding to the present invention, in which its circuit is shown with a power semiconductor element and associated components. In Fig. 4, the same elements as those shown in Figs. 1 and 2 and those in Fig. 14 are designated with the same reference numerals, and their description will be omitted. In Fig. 4, with respect to the reference numerals shown in Figs. 1, 2 and 14, only the representative ones are indicated.

In Fig. 4, reference numeral 1A denotes a gate drive circuit device using a power supply side switching means 3A and a reference potential side switching means 4A instead of the power supply side switching means 3 and the reference potential side switching means 4 in the gate drive circuit device 1 shown in Figs. 1 and 2.

The power source side switching means 3A includes a pEMOS 31A forming a switching device for switching an electric circuit and an auxiliary gate signal generating circuit section 32A for applying an auxiliary gate signal to the gate of the pEMOS 31A for its on/off operation. The auxiliary gate signal generating circuit section 32A receives signal 91a, which is outputted from logic circuit section 91 in the gate drive signal generating circuit section 2 and corresponds to the command signal 11a, and outputs an auxiliary gate signal being "L" when the signal 91a is the on-command signal and being "H" when the signal 91a a is the off-command signal. The reference potential side switching means 4A includes an nEMOS 41A forming the switching circuit for switching the electric circuit and an auxiliary gate signal generating circuit section 42A for applying an auxiliary gate signal to the gate of the nEMOS 41A for its on/off operation. The auxiliary gate signal generating circuit section 42A receives signal 91a, which is outputted from the logic circuit section 91 in the gate drive signal generating circuit section 2 and corresponds to the command signal 11a, and outputs an auxiliary gate signal being "H" when the signal 91a is the on-command signal and being "L" when it is the off-command signal.

In the embodiment 3, the pEMOS 31A and the nEMOS 41A have a withstand voltage higher than the breakdown voltage of the voltage regulation diode 71.

With the above structure of the embodiment shown in Fig. 4, the pEMOS 31A and the nEMOS 41A are turned off simultaneously with the nEMOS 7. When the pEMOS 31A and the nEMOS 41 A are turned off, a voltage due to the counter electromotive force generated at the electromagnetic coil 79 is applied to the pEMOS 31A and the nEMOS 41A with the turning off of the nEMOS 7. With the withstand voltages of the pEMOS 31A and the nEMOS 41A being higher than the breakdown voltage of the voltage regulation diode 71 they can perform the desired operation without any difficulty, even under the voltage due to a counter electromotive force. Therefore, all of the gate drive circuit device 1A can be constituted with electronic circuit parts.

### Embodiment 4:

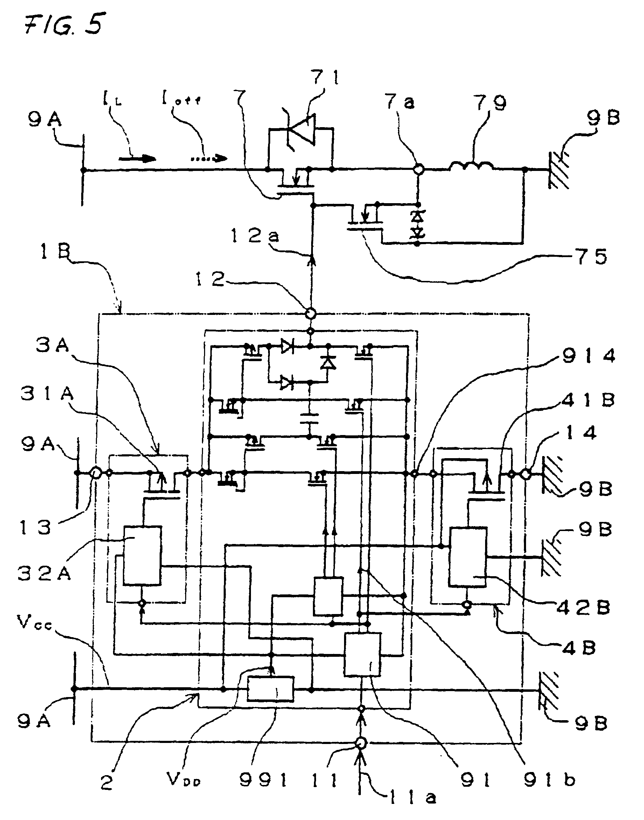

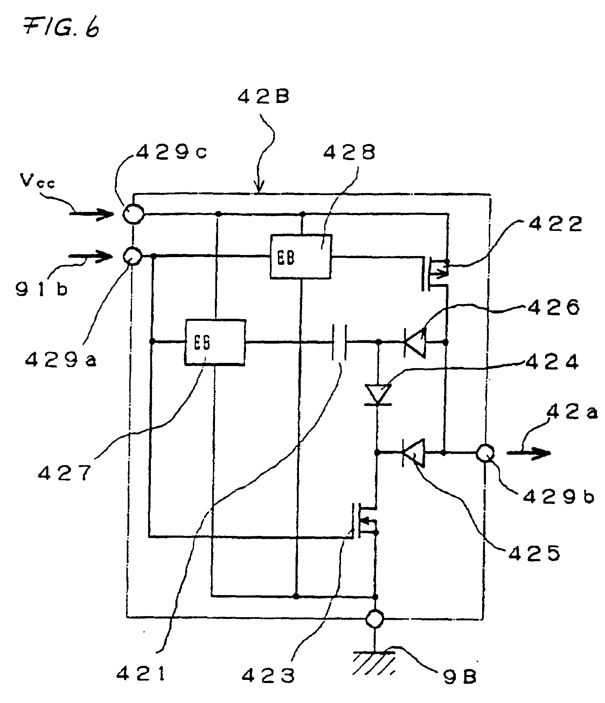

Fig. 5 is a circuit diagram of still another embodiment of a gate drive circuit device for a voltage-driven semiconductor element corresponding to the present invention, in which a power semiconductor element is shown with associated components. Fig. 6 is a circuit diagram showing an auxiliary gate drive signal generating circuit shown in Fig. 5. In Figs. 5 and 6, the same elements as those shown in Figs. 1 and 2, those in Fig. 4 and those in Fig. 14 are designated with the same reference numerals, and their description will be omitted. In Fig. 5, with respect to the reference numerals shown in Figs. 1, 2, 4 and 14, only the representative ones are indicated.

In Fig. 5, reference numeral 1B denotes a gate drive circuit device using a reference potential side switching means 4B instead of the reference potential side switching means 4A in the gate drive circuit device 1 shown in Fig. 4 in accordance with the present invention. The reference potential side switching means 4B includes a pEMOS 41B forming a switching device for switching an electric circuit and an auxiliary gate signal generating circuit section 42B for applying an auxiliary gate signal to the gate of the pEMOS 418 for its on/off operation.

The pEMOS 41B has its source connected to the reference potential terminal 914 provided in the gate drive signal generator 2, its drain connected to the ground line 9B, and a back gate connected to the power supply line 9A. The gate of the pEMOS 41B receives the auxiliary gate signal 42a outputted from the auxiliary gate signal generating circuit section 42B.

The auxiliary gate signal generating circuit section 42B is a circuit device which receives signal 91b (EB), which is the inversion of the command signal 11a and is outputted from the logic circuit 91 provided in the gate drive signal generating circuit section 2, from an input terminal 429a thereof, and outputs from an output terminal 429b thereof an auxiliary gate signal 42a which is "L" when the signal 91b is "H", while "H" when the signal 91b is "L". The auxiliary gate signal generating circuit section 42B includes a capacitor 421, a pEMOS 422, an nEMOS 423, diodes 424 to 426, an oscillating circuit section 427, and a gate signal circuit section 428, and receives a supply voltage V_{cc} from a power supply terminal 429c thereof.

The oscillating circuit section 427 receives the signal 91b, and, when the signal 91b is "H", outputs from an output terminal thereof a cyclic rectangular wave alternating between "H" and "L" at a period shorter than the shortest duration of "H" or "L" of the command signal 11a with "H" being, for example, around 5 volts and "L" being substantially equal to the voltage of the ground line 9B. For the signal 91b being "L", the oscillating circuit section 427 does not output the rectangular wave. The gate signal circuit section 428 is a circuit device which receives the signal 91b and outputs the gate signal for the pEMOS 422. It outputs a gate signal for turning the pEMOS 422 off from its output terminal when the signal 91b is "H" and outputs a gate signal for turning the pEMOS 422 on when the signal 91b is "L".

When the signal 91b is "H", the auxiliary gate signal generating circuit section 42B having the above composition becomes a circuit device which serves as a well-known charging pump that outputs a negative d.c. voltage equivalent to the d.c. voltage applied across a capacitor. Hence, the auxiliary gate signal 42a becomes "H" or "L" in correspondence with the signal 91b being "L" or "H" (accordingly, in correspondence with the command signal 11a being "H" or "L"). The auxiliary gate signal 42a being "H" has a voltage equivalent to that of the ground line 9B. At "L" it has a negative voltage whose absolute value is substantially equal to the value of the signal outputted as "H" from the oscillating circuit section 427.

With the above structure of the embodiment shown in Fig. 5, the pEMOS 41B is used for the voltage-driven semiconductor element forming the reference potential side switching means in contrast to the main semiconductor element nEMOS 7. The back gate of the pEMOS 41B is connected to the power supply line 9A which is the highest potential of the gate drive circuit device 1B. As a result, as was described in detail in the section of the operation, no current path due to a forward-biased p-n junction is formed in the pEMOS 41B even though the gate potential of the nEMOS 7 is lowered below the potential of the ground line 9B by the application of a voltage due to the counter electromotive force generated at the electromagnetic coil 79 as a load. In other words, in the gate drive circuit device 1B, the pEMOS 41B can be integrally formed on the semiconductor substrate where the nEMOS 7 is formed.

Moreover, in the gate drive circuit device having the composition shown in Fig. 5, the source of the pEMOS 41 B is connected to the reference potential terminal 914 provided in the gate drive signal generator 2, and the drain is connected to ground line 9B. The gate of the pEMOS 41B is supplied with the auxiliary gate signal 42a. An "L" level of the auxiliary gate signal 42a for turning the pEMOS 41B on is a negative voltage having an absolute value of the voltage of the "H" level of the signal outputted from the oscillating circuit section 427 (for example, -5 volts). Consequently, even though the pEMOS 41B is turned on and its source potential is lowered to a potential close to that of the ground line 9B, the potential of its gate is lower than that of the source. This enables the pEMOS 41 B to be held in a sufficiently stable state.

### Embodiment 5:

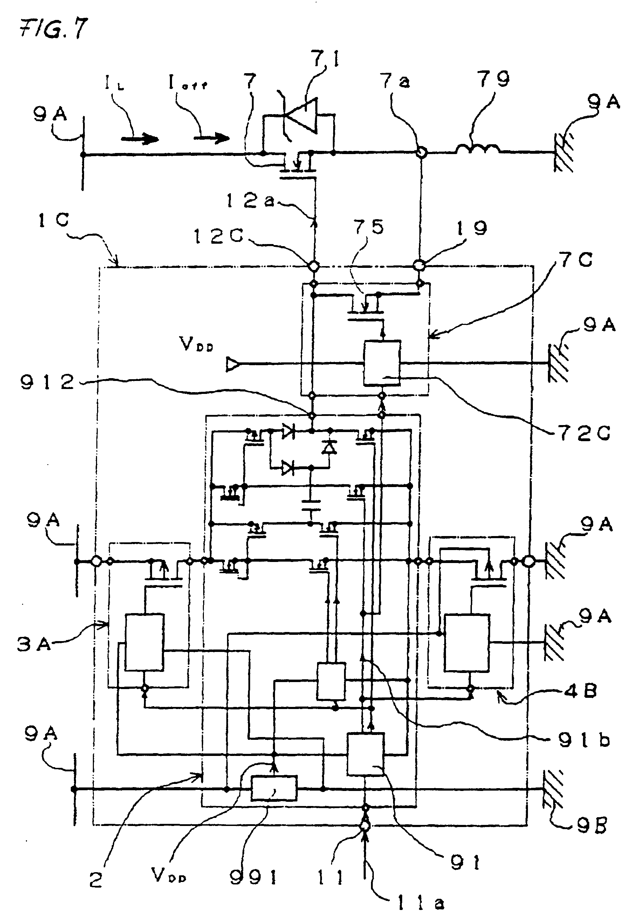

Fig. 7 is a circuit diagram of still another embodiment of a gate drive circuit device for a voltage-driven semiconductor element corresponding to the present invention, in which a power semiconductor element is shown with associated components. In Fig. 7, the same elements as those shown in Figs. 1 and 2, those in Fig. 4, and those in Fig. 14 are designated with the same reference numerals, and their description will be omitted. In Fig. 7, with respect to the reference numerals shown in Figs. 1, 2, 4 and 14, only the representative ones are indicated.

In Fig. 7, reference numeral 1C denotes a gate drive circuit for which a switching means 7C is provided in addition to the gate drive circuit device 1B according to the present invention shown in Figs. 5 and 6 and, an output terminal 12C is provided via the switching means 7C instead of the output terminal 12 provided in the gate drive circuit device 1B. The switching means 7C is a circuit device which functions as the nEMOS 75 and the voltage regulation diodes 75a and 75b in the gate drive circuit devices 1 or 1B, or in the conventional circuit device 9. The switching means 7C includes the nEMOS 75 and an auxiliary gate signal generating circuit section 72C for generating an auxiliary gate signal for driving the gate of the nEMOS 75. The auxiliary gate signal generating circuit section 72C receives signal 91b, which is in inverted relation to the command signal 11a and is outputted from the logic circuit section 91 provided in the gate drive signal generating circuit section 2, and outputs an auxiliary gate signal which is "L" when the signal 91b is "H", while it is "H" when signal 91b is "L". Hence, in the switching means 7C, when the command signal 11a is an on-command being "L" (signal 91b is "H"), the nEMOS 75 is turned off. On the contrary, when the command signal 11a is an off-command being "H" (the signal 91b is "L"), the nEMOS 75 is turned on so that the nEMOS 75 short-circuits the output terminal 12C and the terminal 19 of the gate drive circuit device 1C. The gate of the nEMOS 7 is connected to the output terminal 12C of the gate drive circuit device 1C, and its source is connected to the output terminal 7a and the terminal 19 of the gate drive circuit device 1C.

The above composition of the embodiment shown in Fig. provides the same function as that of the gate drive circuit device 1B and particular operation and effect which will be described below. In this gate drive circuit device 1C, for the command signal 11a switched from the on-command to the off-command, the gate and source of the nEMOS 7 is short-circuited by the nEMOS 75 provided in the switching means 7C. Therefore, a breakdown between the gate and source thereof due to the counter electromotive force generated from the electromagnetic coil 79 is prevented by this device. Moreover, in the switching means 7C, no voltage regulation diodes 75a and 75b are necessary to be provided between the gate and source of the nEMOS 75. The voltage regulation diodes 75a and 75b are the elements for bypassing the gate and source of the nEMOS 75 when a counter electromotive force is generated. Accordingly, they must have a size enough to provide a current capacity corresponding to a magnitude of the current that flows at the time of generation of the counter electromotive force. Therefore, in particularly in forming both the power semiconductor element and its drive circuit on the same semiconductor substrate, its downsizing may be limited by an area occupied by the voltage regulation diodes 75a and 75b. On the contrary, in the switching means 7C according to this embodiment, no need of providing the voltage regulation diodes 75a and 75b enables the semiconductor substrate to be downsized.

### Embodiment 6:

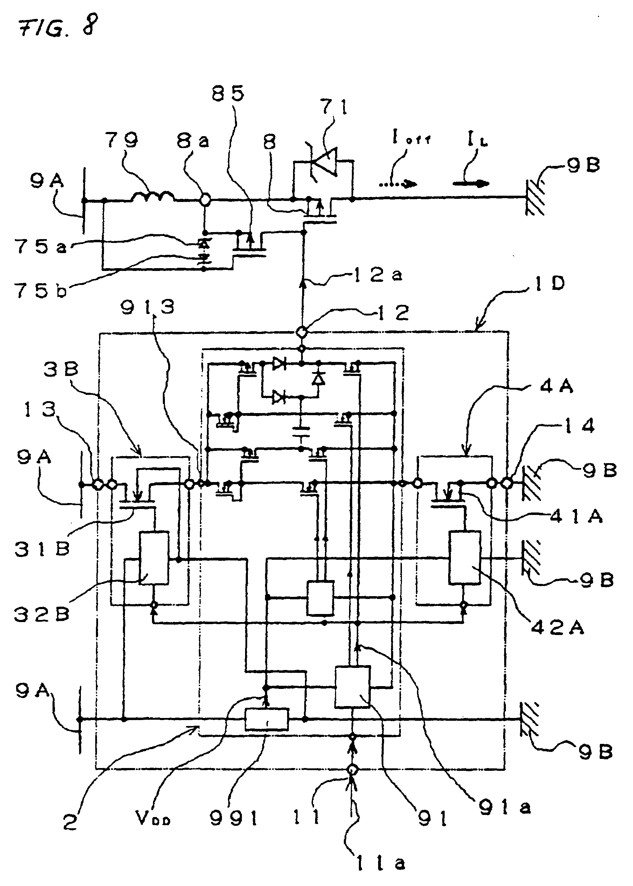

Fig. 8 is a circuit diagram of still another embodiment of a gate drive circuit device for a voltage-driven semiconductor element corresponding to the present invention, in which a power is shown with associated components. In Fig. 8, the same elements as those shown in Figs. 1 and 2, those in Fig. 4, and those in Fig. 14 are designated with the same reference numerals, and their description will be omitted. In Fig. 8, with respect to the reference numerals shown in Figs. 1, 2, 4 and 14, only the representative ones are indicated.

In Fig. 8, reference numeral 1D denotes a gate drive circuit device using a power supply side switching means 3B instead of the power supply side switching means 3A in the gate drive circuit device 1A shown in Fig 4 according to the present invention. The power supply side switching means 3B includes an nEMOS 31B forming the switching device for switching the electric circuit and an auxiliary gate signal generating circuit section 32B for applying an auxiliary gate signal to the gate of the nEMOS 31B for its on/off operation.

The nEMOS 31B has its source connected to the power supply terminal 913 provided in the gate drive signal generator 2 with its drain connected to the power supply line 9A and its back gate connected to the ground line 9B, and its gate receives an auxiliary gate signal outputted from the auxiliary gate signal generating circuit section 32B. The auxiliary gate signal generating circuit section 32B includes a circuit section operating as, for example, a charging pump, and is a circuit device which receives signal 91a (E), which corresponds to the command signal 11a, outputted from the logic circuit section 91 provided in the gate drive signal generating circuit section 2, and outputs an auxiliary gate signal being "H" when the signal 91a is "L", while being "L" when signal 91a is "H". The charging pump provided in the auxiliary gate signal generating circuit section 32B is allowed to output a voltage substantially twice as high as V_{cc} which is a power supply voltage of that circuit device. Consequently, the auxiliary gate signal has a voltage substantially twice as high as V_{cc} while being "H", and substantially equal to that of the ground line 9B while being "L".

In Fig. 8, the main semiconductor element is a pEMOS 8 to which the gate drive circuit device 1D supplies the gate drive signal 12a. Corresponding to the main semiconductor element being pEMOS 8 in this embodiment, a way of connecting the electromagnetic coil 79 as a load and elements such as one for short-circuiting the source and drain of the pEMOS 8 when it is turned off are different from those of the gate drive circuit devices 1 to 1C and the conventional gate drive circuit device 9 according to the well-known manner. Namely, the pEMOS 8 has its drain connected to the ground line 9B and its source connected to one end of the electromagnetic coil 79 through the output terminal 8a. A pEMOS 85 is connected between the gate and source of the pEMOS 8 as shown in the figure. The purpose of the pEMOS 85 in relation to pEMOS 8 is completely identical with that of the nEMOS 75 with respect to the nEMOS 7. However, in this case, the potential of the output terminal 8a is raised higher than the potential of the power supply line 9A by the counter electromotive force generated at the electromagnetic coil 79 when the pEMOS 8 is switched from its on state to off state.

With the above composition of the embodiment shown in Fig. 8, the nEMOS 31B is used for the voltage-driven semiconductor element forming the power supply side switching means for the main semiconductor element pEMOS 8. The back gate of the nEMOS 31B is connected to the ground line 9B which is on the lowest potential of the gate drive circuit device 1D. As a result, as Was described in detail in the section of the operation, no current path due to a forward-biased p-n junction in the nEMOS 31B is formed even though the gate potential of the pEMOS 8 is raised higher than the power supply line 9A by a voltage applied due to the counter electromotive force generated in the electromagnetic coil 79 as a load. This enables, in the gate drive circuit device 1D, the nEMOS 31B to be formed integrally with the pEMOS 8 on the semiconductor substrate.

Moreover, in the gate drive circuit device having the composition shown in Fig. 8, the nEMOS 31B has its source connected to the power supply terminal 913 provided in the gate drive signal generator 2, and its drain connected to power supply line 9A. Also, a gate of the nEMOS 31B is supplied with the auxiliary gate signal outputted from the auxiliary gate signal circuit section 32B. An "H" level of the auxiliary gate signal for turning the nEMOS 31B on is substantially twice as high as, for example, the supply voltage V_{cc}. Consequently, even though the nEMOS 31B is turned on and its source potential is raised to a potential close to that of the power supply line 9A, the potential of the gate thereof is higher than that of the source. This enables the nEMOS 31B to be held in a sufficiently stable state.

### Embodiment 7:

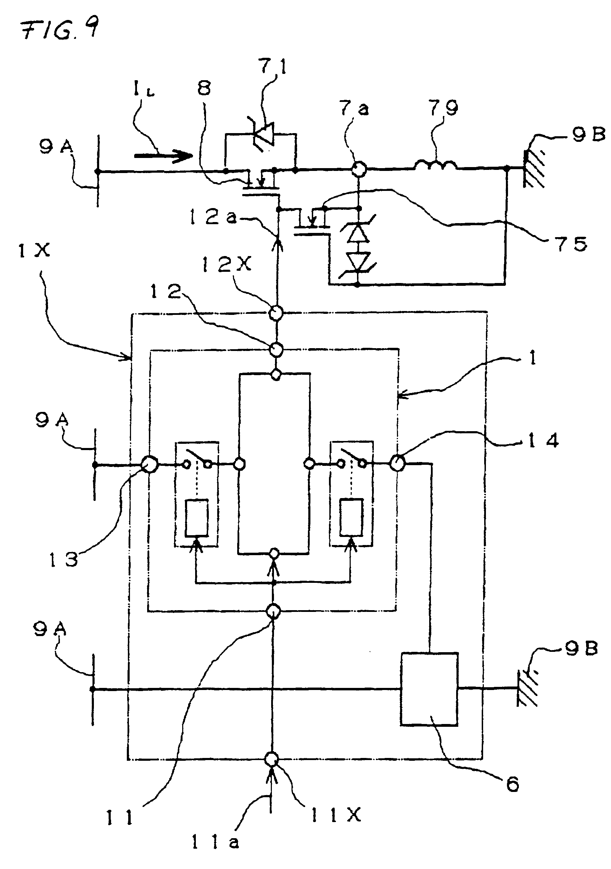

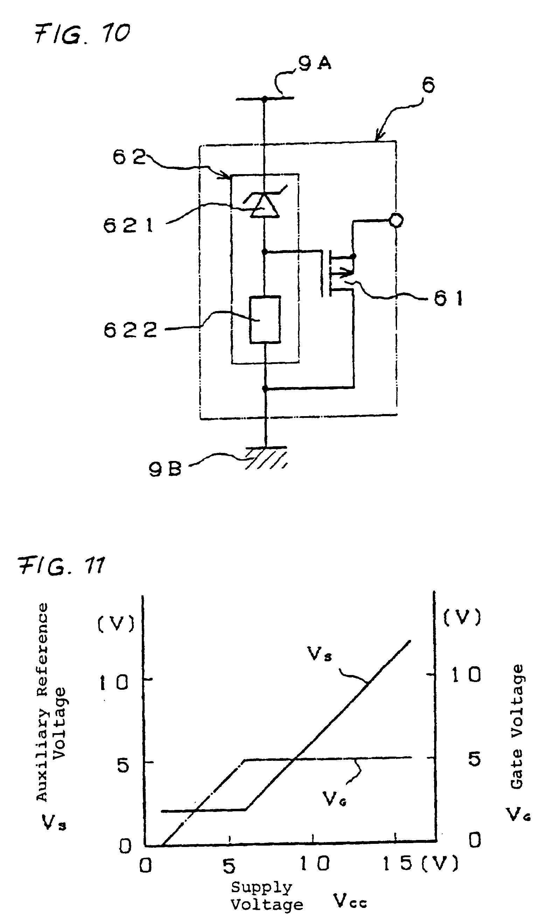

Fig. 9 is a circuit diagram of still another embodiment of a gate drive circuit device for a voltage-driven semiconductor element corresponding to the present invention, in which a power semiconductor element is shown with associated components. Fig. 10 is a circuit diagram showing the auxiliary reference voltage circuit device shown in Fig. 9. In Figs. 9 and 10, the same elements as those shown in Figs. 1 and 2 and those in Fig. 14 are designated with the same reference numerals, and their description will be omitted. In Fig. 9, with respect to the reference numerals shown in Figs. 1, 2 and 14, only the representative ones are indicated.

In Figs. 9 and 10, reference numeral 1X denotes a gate drive circuit device for which an auxiliary reference voltage circuit device 6 are added to the gate drive circuit device 1 shown in Figs. 1 and 2 according to one embodiment of the present invention. As shown in Fig. 10, the auxiliary reference voltage circuit device 6 includes a pEMOS 61 and a constant-voltage circuit device 62 for outputting a gate voltage of a substantially constant value to the gate of the pEMOS 61. The constant-voltage circuit device 62, to which the supply voltage V_{cc} is supplied. has a voltage regulation diode 621 disposed at the power source line 9A side and a resistance element 622 disposed at the ground line 9B side, both being connected in series with a node between them being connected to the gate of the pEMOS 61. The pEMOS 61 has its source connected to the reference potential terminal 14 of the gate drive circuit device 1 and its drain connected to the ground line 9B. Reference numeral 11X denotes an input terminal for inputting the command signal 11a a to the gate drive circuit device 1X.

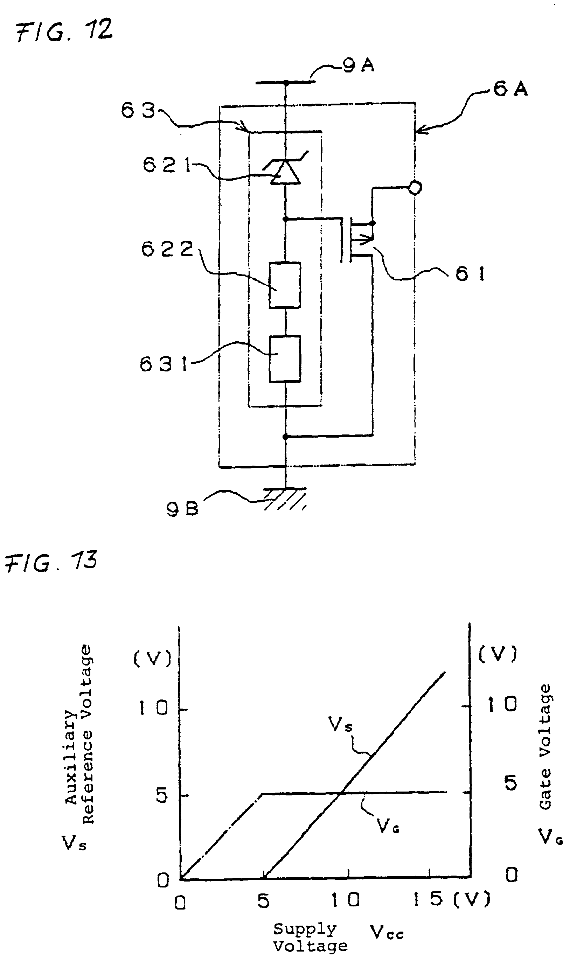

With the above composition of the embodiment shown in Figs. 9 and 10, as was described in the section of the operation, the gate voltage V_{G} applied to the gate of the pEMOS 61 varies with a variation in the supply voltage V_{cc} as shown in Fig. 11 with a change in its variation at the breakdown voltage of the voltage regulation diode 621. The source voltage of the pEMOS 61 driven by its gate voltage V_{G} is provided as an auxiliary reference voltage Vₛ. Hence, the auxiliary reference voltage Vₛ is substantially equal to the voltage difference between the supply voltage V_{cc} and the gate voltage V_{G}. This makes a voltage applied between the power supply terminal 13 and ground potential terminal 14 of the gate drive circuit device 1 substantially equal to the gate voltage V_{G}, which is the difference between the supply voltage V_{cc} and the auxiliary reference voltage Vₛ that can be limited to the breakdown voltage of the voltage regulation diode 621.

### Embodiment 8:

Fig. 12 is a circuit diagram showing an auxiliary reference voltage circuit device applied to still another embodiment of a gate drive circuit device for a voltage-driven semiconductor element corresponding to claims 7, 8 and 10 of the present invention. In Fig. 12, the same elements as those shown in Fig. 10 illustrating the auxiliary reference voltage circuit device applied to still another embodiment of the gate drive circuit device for the voltage-driven semiconductor element corresponding to claims 7 to 9 of the present invention are designated with the same reference numerals, and their description will be omitted.

In Fig. 12, reference numeral 6A denotes a circuit device using the constant-voltage circuit device 63 instead of the constant-voltage circuit device 62 in the auxiliary reference voltage circuit device 6 as shown in Fig. 10 according to still another embodiment of the present invention. The constant-voltage circuit device 63 differs from the constant-voltage circuit device 62 in providing a negative voltage generator 631 that is connected between the resistance element 622 and the ground line 9B.

With the above composition of the embodiment shown in Fig. 12, as was described in the section of the operation, the gate voltage V_{G} applied to the gate of the pEMOS 61 varies with a variation in the supply voltage V_{cc} as shown in Fig. 13 with a change in its variation at a voltage equivalent to the difference between the breakdown voltage of the voltage regulation diode 621 and the voltage across the negative voltage generator 631. In Fig. 13, it can be observed that a range of the supply voltage V_{cc}, in which the difference between the supply voltage V_{cc} and the auxiliary reference voltage Vₛ is held at a constant value corresponding to the breakdown voltage of the voltage regulation diode 621 is expanded toward lower voltages by an amount of voltage generated by the negative voltage generator 631.

In the above description of the embodiments 7 and 8, the gate drive circuit device 1X has been described as including the auxiliary reference voltage circuit devices 6 or 6A added to the gate drive circuit device 1. However, it is not limited to this composition and modification is possible so that, for example, the gate drive circuit device 1 may be any of the gate drive circuit devices 1A to 1D.

### EFFECTS OF THE INVENTION

With the above structure, the present invention has the following advantages.
(1) The voltage due to the counter electromotive force generated at a load at the turning off of the power semiconductor element is applied to the power semiconductor element and the voltage stabilizing means by turning both the power supply side switching means and the reference potential side switching means off. For this, the operating voltage of the voltage stabilizing means being set to a value slightly lower than the withstand voltage of the power semiconductor element, the voltage stabilizing means or the power semiconductor element is enabled to absorb an increased amount of energy per unit time compared with that of the prior art. Hence, the electromagnetic energy W_{L} stored in the inductive load can be absorbed in a short period of time, as a result of which the electric equipment can be operated at a high speed.
(2) When the power supply side switching means and/or the reference potential switching means are comprised of a voltage-driven semiconductor element having a withstand voltage higher than an operating voltage of the voltage stabilizing means for protecting the main voltage-driven semiconductor element from over-voltage, the gate drive circuit device having the advantage described in the paragraph (1) can be entirely constituted with electronic circuit parts with improved reliability.
(3) In case of the above paragraph (2), the power supply side switching means or the reference potential side switching means may be comprised of a voltage-driven semiconductor element having a channel of a conductivity type different from that of a channel of the main voltage-driven semiconductor element, and the back gate of the voltage-driven semiconductor element is connected to a portion having a potential higher than that of its main electrode connected to the gate drive signal generator side in the case of the reference potential side switching means, and, in the case of the power supply side switching means, to a portion having a potential tower than that of its main electrode. As a result, there is no formation of a current path due to a forward-biased p-n junction in the voltage-driven semiconductor element forming the switching means even though the gate potential of the main semiconductor element is adversely affected by the counter electromotive force generated at the inductive load at the turn-off of the main semiconductor element. Consequently, the voltage-driven semiconductor element forming the switching means can be formed integrally on the same semiconductor substrate on which the main voltage-driven semiconductor element is formed, which facilitates an inexpensive production of the downsized gate drive circuit device having the advantages described in the above paragraphs (1) and (2).
(4) In case of the above paragraph (3), there may be provided an auxiliary gate drive signal generator for outputting an auxiliary gate drive signal which is in synchronization with a command signal and has a voltage tower than that of the reference potential when the command signal is an on-command, and the voltage-driven semiconductor element of the reference potential side switching means has its gate driven by the auxiliary gate drive signal, one main electrode thereof connected to the reference potential, and the other main electrode connected to the gate drive signal generator. Or, there may be provided an auxiliary gate drive signal generator for outputting an auxiliary gate drive signal which is in synchronization with a command signal and has a voltage higher than that of the power supply when the command signal is an on-command, and the voltage-driven semiconductor element of the power supply side switching means has its gate driven by the auxiliary gate drive signal, one main electrode thereof connected to the power supply, and the other main electrode connected to the gate drive signal generator. With this, the voltage-driven semiconductor element forming the switching means can be held in a sufficiently stable on-state, so that a voltage drop between the source and drain of these turned on semiconductor elements can be reduced. As a result, for example, the gate drive circuit device can be used under a reduced supply voltage V_{cc}.
(5) There is provided an auxiliary reference circuit device for outputting an auxiliary reference voltage that varies in accordance with a variation of the supply voltage such that the power supply of the gate drive signal generator is supplied from between the supply voltage of the gate drive circuit device and the auxiliary reference circuit device. With this composition, even though the supply voltage varies, a voltage supplied to the gate drive signal generator is regulated to be equal to or under the breakdown voltage of the voltage regulation diode. As a result, a voltage applied across an electronic part constituting the gate drive signal generator, for example, a capacitor provided in a charging pump, can be restrained to the same level as the breakdown voltage of the voltage regulation diode at the highest. This enables the gate drive circuit device to have a reduced current consumption and an elongated life.
(6) In case of the above paragraph (5), the constant-voltage circuit device provided in the auxiliary reference circuit device may be composed to additionally include a negative voltage generating circuit device. As a result, a range of the supply voltage, in which the difference between the supply voltage and the auxiliary reference voltage generated from the auxiliary reference circuit device is substantially constant as being equal to the breakdown voltage of the voltage regulation diode, can be expanded toward a lower voltage range by an amount of voltage generated from the negative voltage generating circuit device. Thus, the advantage described in the above paragraph (5) can be obtained in a wider range of the supply voltage.

## Claims

1. A gate drive circuit device for applying a gate drive signal to a gate of a main voltage-driven semiconductor element (7; 8) having one main electrode thereof connected to a power supply (9A) or a reference potential point (9B) and the other main electrode thereof connected to a load (79), the gate drive circuit device comprising
a gate drive signal generator (2) responsive to a command signal commanding the on/off operation of said main semiconductor element, for generating a gate drive signal corresponding to the command signal;
a power supply side switching means (3; 3A; 3B) disposed between a power supply (9A) and said gate drive signal generator (2); and
a reference potential side switching means (4; 4A, 4B) disposed between said gate drive signal generator (2) and the reference potential point (9B; 6, 9B),
wherein said power supply side switching means (3; 3A; 3B) and said reference potential side switching means (4; 4A, 4B) are turned on when the command signal is an on-command and turned off when it is an off-command.

2. The device of claim 1, further comprising voltage stabilizing means (71), and wherein said power supply side switching means (3A; 3B) and/or said reference potential side switching means (4A; 4B) comprises a voltage-driven semiconductor element (31A, 31B, 41A, 41B) having a withstand voltage higher than an operating voltage of said voltage stabilizing means (71).

3. The device of claim 2, wherein said reference potential side switching means (4B) comprises a voltage-driven semiconductor element (41B) having a channel of a conductivity type different from that of a channel of said main voltage-driven semiconductor element (7), and said voltage-driven semiconductor element of said reference potential side switching means has a back gate connected to a point of a potential higher than that of a main electrode thereof which is connected to the gate drive signal generator side.

4. The device of claim 2 or 3, further comprising an auxiliary gate drive signal generator (42B) for outputting an auxiliary gate drive signal which is in synchronism with the command signal and has a voltage lower than that of the reference potential when the command signal is an on-command, wherein said voltage-driven semiconductor element (41B) of said reference potential side switching means (4B) has a gate driven by said auxiliary gate drive signal, one main electrode connected to the reference potential point (9B) and the other main electrode connected to said gate drive signal generator (2).

5. The device of claim 2, wherein said power supply side switching means (3B) comprises a voltage-driven semiconductor element (31B) having a channel of a conductivity type different from that of a channel of said main voltage-driven semiconductor element (8), and said voltage-driven semiconductor element of said power supply side switching means has a back gate connected to a point having a potential lower than that of a main electrode thereof connected to the gate drive signal generator side.

6. The device of claim 2 or 5, further comprising an auxiliary gate drive signal generator (32B) for outputting an auxiliary gate drive signal which is in synchronism with the command signal and has a voltage higher than that of the power supply when the command signal is an on-command, wherein said voltage-driven semiconductor element (31B) of said power supply side switching means (3B) has a gate thereof driven by said auxiliary gate drive signal, one main electrode connected to the power supply and the other main electrode thereof connected to said gate drive signal generator (2).

7. The device of any one of the preceding claims further comprising an auxiliary reference voltage circuit device (6; 6A) connected between the power supply (9A) and the reference potential point (9B) and having an output for outputting an auxiliary reference voltage, wherein said reference potential side switching means is disposed between said gate drive signal generator and said output of the auxiliary reference voltage circuit device (6; 6A), and wherein said auxiliary reference voltage has an intermediate value between the power supply voltage and the voltage of the reference potential and varies in accordance with a variation of the power supply voltage so as to maintain the difference between said auxiliary reference voltage and the power supply voltage substantially constant.

8. The device of claim 7, wherein said auxiliary reference voltage circuit device (6) has a voltage-driven semiconductor element (61) and a constant-voltage circuit device (62; 63) for outputting a gate voltage to a gate of said semiconductor element, the difference between said gate voltage and the supply voltage being maintained substantially constant, said semiconductor element has one main electrode thereof connected to the reference potential side and the other main electrode thereof from which the auxiliary reference voltage is outputted, and said constant-voltage circuit device is connected between the power supply (9A) and the reference potential point (9B).

9. The device of claim 8, wherein said constant-voltage circuit device (62) includes a voltage regulation diode (621) and a resistance element (622), said voltage regulation diode is arranged at the power supply side and said resistance element is arranged at the reference potential side so that said voltage regulation diode and said resistance element are connected in series to each other, and said gate voltage is outputted from a node between said voltage regulation diode and said resistance element.

10. The device of claim 8, wherein said constant-voltage circuit device (63) includes a voltage regulation diode (621), a resistance element (622) and a negative voltage generating circuit device (631), said voltage regulation diode is arranged at the power supply side and a series circuit consisting of said resistance element and said negative voltage generating circuit device is arranged at the reference potential side so that said voltage regulation diode and said series circuit are connected in series to each other, and said gate voltage is outputted from a node between said voltage regulation diode and said series circuit consisting of said resistance element and said negative voltage generating circuit device.

11. The device of any one of the preceding claims, wherein a voltage stabilizing means (71) for protecting said main semiconductor element (7; 8) from an over-voltage is connected to said main semiconductor element.

12. The device of any one of the preceding claims, further comprising additional switching means (7C) including a voltage-driven semiconductor element (75) and control means (72C, 91) for switching said semiconductor element (75) on in response to an off-command and off in response to an on-command, said semiconductor element (75) having one main electrode connected to the gate of said main semiconductor element (7), another main electrode connected to the load side main electrode of the main semiconductor element (7) and the gate connected to said control means (72C, 91).

## Patentansprüche

1. Gate-Ansteuerschaltungsvorrichtung zum Anlegen eines Gate-Ansteuersignals an ein Gate eines spannungsgesteuerten Haupthalbleiterelements (7; 8), dessen eine Hauptelektrode an eine Stromversorgung (9A) oder einen Bezugspotentialpunkt (9B) und dessen andere Hauptelektrode an eine Last (79) angeschlossen ist, wobei die Gate-Ansteuerschaltungsvorrichtung folgendes aufweist:
einen Gate-Ansteuersignalgenerator (2), der auf ein den EIN/AUS-Betrieb des Haupthalbleiterelements befehlendes Befehlssignal anspricht und ein Gate-Ansteuersignal entsprechend dem Befehlssignal erzeugt;
eine Schalteinrichtung (3; 3A, 3B) der Stromversorgungsseite, die zwischen einer Stromversorgung (9A) und dem Gate-Ansteuersignalgenerator (2) angeordnet ist; und
eine Schalteinrichtung (4; 4A, 4B) der Bezugspotentialseite, die zwischen dem Gate-Ansteuersignalgenerator (2) und dem Bezugspotentialpunkt (9B; 6, 9B) angeordnet ist,
wobei die stromversorgungsseitige Schalteinrichtung (3; 3A; 3B) und die bezugspotentialseitige Schalteinrichtung (4; 4A, 4B) eingeschaltet werden, wenn das Befehissignal ein EIN-Befehl ist, und ausgeschaltet, wenn es ein AUS-Befehl ist.

2. Vorrichtung nach Anspruch 1, ferner mit einer Spannungsstabilisiereinrichtung (71), und bei der die stromversorgungsseitige Schalteinrichtung (3A; 3B) und/oder die bezugspotentialseitige Schalteinrichtung (4A; 4B) ein spannungsgesteuertes Halbleiterelement (31A, 31B, 41A, 41B) aufweist, dessen Spannungsfestigkeit größer ist als eine Betriebsspannung der Spannungsstabilisiereinrichtung (71).

3. Vorrichtung nach Anspruch 2, bei der die bezugspotentialseitige Schalteinrichtung (4B) ein spannungsgesteuertes Halbleiterelement (41B) aufweist, das einen Kanal eines anderen Leitfähigkeitstyps hat als ein Kanal des spannungsgesteuerten Haupthalbleiterelements (7), und das spannungsgesteuerte Halbleiterelement der bezugspotentialseitigen Schalteinrichtung ein rückseitiges Gate hat, welches mit einem Punkt eines höheren Potentials als dem seiner Hauptelektrode verbunden ist, die mit der Gate-Ansteuersignalgeneratorseite verbunden ist.

4. Vorrichtung nach Anspruch 2 oder 3, ferner mit einem Gate-Hilfsansteuersignalgenerator (42B) zur Ausgabe eines Gate-Hilfsansteuersignals, welches mit dem Befehlssignal synchronisiert ist und eine Spannung hat, die niedriger ist als die des Bezugspotentials, wenn das Befehlssignal ein EIN-Befehl ist, wobei das spannungsgesteuerte Halbleiterelement (41B) der bezugspotentialseitigen Schalteinrichtung (4B) ein Gate hat, welches von dem Gate-Hilfsansteuersignal angesteuert wird, und eine Hauptelektrode, die mit dem Bezugspotentialpunkt (9B) verbunden ist, während die andere Hauptelektrode mit dem Gate-Ansteuersignalgenerator (2) verbunden ist.

5. Vorrichtung nach Anspruch 2, bei der die stromversorgungsseitige Schatteinrichtung (3B) ein spannungsgesteuertes Halbleiterelement (31B) aufweist, das einen Kanal eines anderen Leitfähigkeitstyps als ein Kanal des spannungsgesteuerten Haupthalbleiterelements (8) hat, und das spannungsgesteuerte Halbleiterelement der stromversorgungsseitigen Schalteinrichtung ein rückseitiges Gate hat, welches mit einem Punkt verbunden ist, dessen Potential niedriger ist als das einer Hauptelektrode desselben, die mit der Gate-Ansteuersignalgeneratorseite verbunden ist.

6. Vorrichtung nach Anspruch 2 oder 5, ferner mit einem Gate-Hilfsansteuersignalgenerator (32B) zur Ausgabe eines Gate-Hilfsansteuersignals, welches mit dem Befehlssignal synchronisiert ist und eine höhere Spannung hat als die der Stromversorgung, wenn das Befehlssignal ein EIN-Befehl ist, wobei das spannungsgesteuerte Halbleiterelement (31 B) der stromversorgungsseitigen Schalteinrichtung (3B) ein Gate hat, das von dem Gate-Hilfsansteuersignal angesteuert wird, und eine Hauptelektrode, die mit der Stromversorgung verbunden ist, während die andere Hauptelektrode desselben mit dem Gate-Ansteuersignalgenerator (2) verbunden ist.

7. Vorrichtung nach einem der vorhergehenden Ansprüche, ferner mit einer Zusatzbezugsspannungs-Schaltungsvorrichtung (6; 6A), die zwischen die Stromversorgung (9A) und den Bezugspotentialpunkt (9B) geschaltet ist und einen Ausgang zur Ausgabe einer Zusatzbezugsspannung hat, wobei die bezugspotentialseitige Schalteinrichtung zwischen dem Gate-Ansteuersignalgenerator und dem Ausgang der Zusatzbezugsspannungs-Schaltungsvorrichtung (6; 6A) angeordnet ist, und wobei die Zusatzbezugsspannung einen Zwischenwert zwischen der Spannung der Stromversorgung und der Spannung des Bezugspotentials hat und sich in Übereinstimmung mit einer Änderung der Spannung der Stromversorgung ändert, um die Differenz zwischen der Zusatzbezugsspannung und der Spannung der Stromversorgung im wesentlichen konstant zu halten.

8. Vorrichtung nach Anspruch 7, bei der die Zusatzbezugsspannungs-Schattungsvorrichtung (6) ein spannungsgesteuertes Halbleiterelement (61) und eine Konstantspannungs-Schaltungsvorrichtung (62; 63) zur Ausgabe einer Gate-Spannung an ein Gate des Halbleiterelements hat, wobei die Differenz zwischen der Gate-Spannung und der Speisespannung im wesentlichen konstant gehalten wird, und das Halbleiterelement eine mit der Bezugspotentialseite verbundene Hauptelektrode hat und die andere Hauptelektrode, von der die Zusatzbezugsspannung ausgegeben wird, und wobei die Konstantspannungs-Schaltungsvorrichtung zwischen die Stromversorgung (9A) und den Bezugspotentialpunkt (9B) geschaltet ist.

9. Vorrichtung nach Anspruch 8, bei der die Konstantspannungs-Schaltungsvorrichtung (62) eine Spannungsregeldiode (621) und ein Widerstandselement (622) umfaßt, wobei die Spannungsregeldiode an der Stromversorgungsseite und das Widerstandselement an der Bezugspotentialseite angeordnet ist, so daß die Spannungsregeldiode und das Widerstandselement zueinander in Reihe geschaltet sind, und wobei die Gate-Spannung von einem Knoten zwischen der Spannungsregeldiode und dem Widerstandselement ausgegeben wird.

10. Vorrichtung nach Anspruch 8, bei der die Konstantspannungs-Schaltungsvorrichtung (63) eine Spannungsregeldiode (621), ein Widerstandselement (622) und eine negative Spannung erzeugende Schaltungsvorrichtung (631) umfaßt, wobei die Spannungsregeldiode an der Stromversorgungsseite angeordnet ist und eine Reihenschaltung aus dem Widerstandselement und der negative Spannung erzeugenden Schaltungsvorrichtung an der Bezugspotentialseite angeordnet ist, so daß die Spannungsregeldiode und die Reihenschaltung miteinander in Reihe geschaltet sind, und die Gate-Spannung von einem Knoten zwischen der Spannungsregeldiode und der aus dem Widerstandselement und der negative Spannung erzeugenden Schaltungsvorrichtung bestehenden Reihenschaltung ausgegeben wird.

11. Vorrichtung nach einem der vorhergehenden Ansprüche, bei der eine Spannungsstabilisiereinrichtung (71) zum Schützen des Haupthafbleiterelements (7; 8) vor Überspannung mit dem Haupthalbleiterelement verbunden ist.

12. Vorrichtung nach einem der vorhergehenden Ansprüche, ferner mit einer zusätzlichen Schalteinrichtung (7C), die ein spannungsgesteuertes Halbleiterelement (75) und eine Steuereinrichtung (72C, 91) zum Einschalten des Halbleiterelements (75) in Abhängigkeit von einem AUS-Befehl und zum Abschalten in Abhängigkeit von einem EIN-Befeht umfaßt, wobei das Halbleiterelement (75) eine Hauptelektrode hat, die mit dem Gate des Haupthalbleiterelements (7) verbunden ist, eine weitere Hauptelektrode, die mit der lastseitigen Hauptelektrode des Haupthalbleiterelements (7) verbunden ist und das Gate, welches mit der Steuereinrichtung (72C, 91) verbunden ist.

## Revendications

1. Dispositif d'attaque de grille destiné à appliquer un signal d'attaque de grille à une grille d'un d'élément (7 ; 8) semi-conducteur principal commandé par tension ayant son électrode principale connectée à une alimentation (9A) ou à un point (9B) de potentiel de référence et son autre électrode principale connectée à une charge (79), le dispositif d'attaque de grille comportant:
un générateur (2) de signaux d'attaque de grille répondant à un signal de commande commandant le fonctionnement en marche/arrêt de l'élément à semi-conducteur principal, en générant un signal d'attaque de grille correspondant au signal de commande ;
un moyen (3 ; 3A ; 3B) de commutation du côté de l'alimentation, disposé entre une alimentation (9A) et le générateur (2) de signaux d'attaque de grille ; et
un moyen (4 ; 4A, 4B) de commutation du côté du potentiel de référence, disposé entre le générateur (2) de signaux d'attaque de grille et le point (9B ; 6, 9B) de potentiel de référence,
dans lequel le moyen (3 ; 3A ; 3B) de commutation du côté de l'alimentation et le moyen (4 ; 4A, 4B) de commutation du côté du potentiel de référence sont mis sous tension lorsque le signal de commande est une commande de marche et hors tension lorsque c'est une commande d'arrêt

2. Dispositif suivant la revendication 1 comprenant en outre, un moyen (71) de stabilisation de tension, et dans lequel le moyen (3A ; 3B) de commutation du côté de l'alimentation et/ou le moyen (4A; 4B) de commutation du côté du potentiel de référence comprennent un élément (31A, 31B, 41A, 41B) à semi-conducteur commandé par tension ayant une tension de retenue supérieure à une tension de fonctionnement du moyen (71 ) de stabilisation de tension.

3. Dispositif suivant la revendication 2, dans lequel le moyen (4B) de commutation du côté du potentiel de référence comprend un élément (41 B) à semi-conducteur commandé par tension ayant un canal d'un type de conductivité différent de celui d'un canal de l'élément (7) semi-conducteur principal commandé par tension, et l'élément à semi-conducteur commandé par tension du moyen de commutation du côté du potentiel de référence a un substrat connecté à un point d'un potentiel supérieur à celui d'une électrode principale de celui-ci qui est connectée du côté du générateur de signaux d'attaque de grille.

4. Dispositif suivant la revendication 2 ou 3, comprenant en outre un générateur (42B) de signaux d'attaque de grille auxiliaires, destiné à délivrer un signal d'attaque de grille auxiliaire qui est en synchronisme avec le signal de commande et a une tension inférieure à celle du potentiel de référence, lorsque le signal de commande est une commande de marche, dans lequel l'élément (41 B) semi-conducteur commandé par tension du moyen (4B) de commutation du côté du potentiel de référence a une grille attaquée par le signal d'attaque de grille auxiliaire, une électrode principale connectée au point (9B) de potentiel de référence et l'autre électrode principale connectée au générateur (2) de signaux d'attaque de grille.

5. Dispositif suivant la revendication 2, dans lequel le moyen (3B) de commutation du côté de l'alimentation comprend un élément (31B) semi-conducteur commandé par tension ayant un canal d'un type de conductivité différent de celui d'un canal de l'élément (8) à semi-conducteur principal commandé par tension, et l'élément à semi-conducteur commandé par tension du moyen de commutation du côté de l'alimentation a un substrat connecté à un point ayant un potentiel inférieur à celui d'une électrode principale de celui-ci, connectée du côté du générateur de signaux d'attaque de grille.

6. Dispositif suivant la revendication 2 ou 5, comprenant en outre un générateur (32B) de signaux d'attaque de grille auxiliaires, destiné à délivrer un signal d'attaque de grille auxiliaire qui est en synchronisme avec le signal de commande et a une tension supérieure à celle de l'alimentation, lorsque le signal de commande est une commande de marche, dans lequel l'élément (31 B) à semi-conducteur commandé par tension du moyen (3B) de commutation du côté de l'alimentation a une grille de celui-ci attaquée par le signal d'attaque de grille auxiliaire, une électrode principale connectée à l'alimentation et l'autre électrode principale de celui-ci connectée au générateur (2) de signaux d'attaque de grille.

7. Dispositif suivant l'une quelconque des revendications précédentes comprenant en outre un dispositif (6 ; 6A) de tension de référence auxiliaire, connecté entre l'alimentation (9A) et le point (9B) de potentiel de référence et ayant une sortie destinée à délivrer une tension de référence auxiliaire, dans lequel le moyen de commutation du côté du potentiel de référence est disposé entre le générateur de signaux d'attaque de grille et le dispositif (6 ; 6A) de tension de référence auxiliaire, et dans lequel la tension de référence auxiliaire a une valeur intermédiaire entre la tension d'alimentation et la tension du potentiel de référence et varie suivant une variation de la tension d'alimentation, de façon à maintenir sensiblement constante la différence entre la tension de référence auxiliaire et la tension d'alimentation.

8. Dispositif suivant la revendication 7, dans lequel le dispositif (6) de tension de référence auxiliaire a un élément (61) à semi-conducteur commandé par tension et un dispositif (62 ; 63) à tension constante, destiné à délivrer une tension de grille à une grille de l'élément à semi-conducteur, la différence entre la tension de grille et la tension d'alimentation étant maintenue sensiblement constante, l'élément à semi-conducteur a une électrode principale de celui-ci connectée du côté du potentiel de référence et l'autre électrode principale de celui-ci à partir de laquelle la tension de référence auxiliaire est délivrée, et le dispositif à tension constante est connecté entre l'alimentation (9A) et le point (9B) de potentiel de référence.

9. Dispositif suivant la revendication 8, dans lequel le dispositif (62) à tension constante comprend une diode (621) de régulation de tension et un élément (622) résistant, la diode de régulation de tension est disposée du côté de l'alimentation et l'élément résistant est disposé du côté du potentiel de référence, de sorte que la diode de régulation de tension et l'élément résistant sont montés en série l'un et l'autre, et que la tension de grille est délivrée à partir d'un noeud entre la diode de régulation de tension et l'élément résistant.

10. Dispositif suivant la revendication 8, dans lequel le dispositif (63) à tension constante comprend une diode (621) de régulation de tension, un élément (622) résistant et un dispositif (631) générateur de tension négative, . la diode de régulation de tension est disposée du côté de l'alimentation et un circuit série composé de l'élément résistant et du circuit générateur de tension négative est disposé du côté du potentiel de référence, de sorte que la diode de régulation de tension et le circuit série sont montés en série l'un et l'autre, et que la tension de grille est délivrée à partir d'un noeud entre la diode de régulation de tension et le circuit série composé de l'élément résistant et du dispositif générateur de tension négative.

11. Dispositif suivant l'une quelconque des revendications précédentes, dans lequel un moyen (71) de stabilisation de tension, destiné à protéger l'élément (7 ; 8) à semi-conducteur principal contre une surtension est connecté à l'élément à semi-conducteur principal.

12. Dispositif suivant l'une quelconque des revendications précédentes, comprenant en outre un moyen (7C) de commutation supplémentaire comportant un élément (75) à semi-conducteur commandé par tension et un moyen (72C, 91 ) de commande, destiné à mettre l'élément (75) à semi-conducteur sous tension, en réponse à une commande d'arrêt et hors tension, en réponse à une commande de marche, l'élément (75) à semi-conducteur ayant une électrode principale connectée à la grille de l'élément (7) à semi-conducteur principal, une autre électrode principale connectée à l'électrode principale du côté de la charge de l'élément (7) à semi-conducteur principal et la grille connectée au moyen (72C, 91) de commande.
